# EUROPEAN PATENT SPECIFICATION

(11) **EP 1 031 073 B1**
(45) Date of publication and mention of the grant of the patent: **24.09.2003**
(21) Application number: 98953872.3
(22) Date of filing: 22.10.1998
(51) Int. Cl.: G06F 7/00

(54) **A METHOD AND APPARATUS FOR MULTI-FUNCTION ARITHMETIC**
EIN VERFAHREN UND GERÄT MIT MEHREREN ARITHMETISCHEN FUNKTIONEN
PROCEDE ET APPAREIL D'ARITHMETIQUE MULTIFONCTIONNELLE

(30) Priority: 23.10.1997 US 63600 P; 23.10.1997 US 63601 P; 28.01.1998 US 14455; 28.01.1998 US 14454; 27.03.1998 US 49789; 27.03.1998 US 49854; 27.03.1998 US 49752; 08.05.1998 US 74826; 08.05.1998 US 75073; 08.05.1998 US 75418; 14.08.1998 US 134171
(43) Date of publication of application: 30.08.2000
(73) Proprietor: ADVANCED MICRO DEVICES INC., Sunnyvale, California 94088-3453 (US)
(72) Inventor: OBERMAN, Stuart, F., Sunnyvale, CA 94086 (US); JUFFA, Norbert, San Jose, CA 95134 (US); SIU, Ming, San Jose, CA 95132 (US); WEBER, Frederick, D., San Jose, CA 95125 (US); CHERUKURI, Ravi, Krishna, Milpitas, CA 95035 (US)
(74) Representative: Brookes Batchellor
(86) International application number: US9822346
(87) International publication number: WO99021078

(56) References cited:
- EP-A- 0 239 899
- EP-A- 0 383 965
- EP-A- 0 754 998
- US-A- 4 849 923
- US-A- 5 343 416
- US-A- 5 606 677

## Description

### BACKGROUND OF THE INVENTION

### 1. Field of the Invention

This invention relates generally to the field of microprocessors and, more particularly, to multipliers in microprocessors.

### 2. Description of the Related Art

Microprocessors are typically designed with a number of "execution units" that are each optimized to perform a particular set of functions or instructions. For example, one or more execution units within a microprocessor may be optimized to perform memory accesses, i.e., load and store operations. Other execution units may be optimized to perform general arithmetic and logic functions, e.g., shifts and compares. Many microprocessors also have specialized execution units configured to perform more complex arithmetic operations such as multiplication and reciprocal operations. These specialized execution units typically comprise hardware that is optimized to perform one or more particular arithmetic functions. In the case of multiplication, the optimized hardware is typically referred to as a "multiplier."

In older microprocessors, multipliers were implemented using designs that conserved die space at the expense of arithmetic performance. Until recently, this was not a major problem because most applications, i.e., non-scientific applications such as word processors, did not frequently generate multiplication instructions. However, recent advances in computer technology and software are placing greater emphasis upon multiplier performance. For example, three dimensional computer graphics, rendering, and multimedia applications all rely heavily upon a microprocessor's arithmetic capabilities, particularly multiplication and multiplication-related operations. As a result, in recent years microprocessor designers have favored performance-oriented designs that use more die space. Some multipliers attempted to compensate for this by multiplying either one pair of integers or two pairs of integers. One such multiplier is disclosed in European Patent Application No A1 0 239 899 by Kabushiki Kaisha Toshiba, entitled "Multiplier array circuit", and published on 07.10.87. Unfortunately, the increased die space needed for these high performance multipliers reduces the space available for other execution units within the microprocessor. Thus, a mechanism for increasing multiplier performance while conserving die space in needed.

Prior art document US-A-5 606 677 discloses a multiplier which enables multiplication of packed data. Rounding is carried out. Multiplication and rounding are performed by using several instructions.

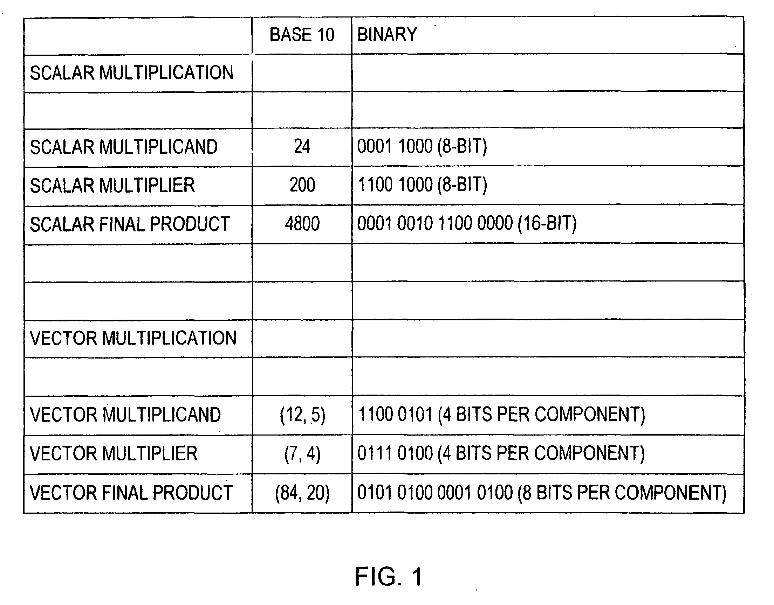

The die space used by multipliers is of particular importance to microprocessor designers because many microprocessors, e.g., those configured to execute MMX™ (multimedia extension) or 3D graphics instructions, may use more than one multiplier. MMX and 3D graphics instructions are often implemented as "vectored" instructions. Vectored instructions have operands that are partitioned into separate sections, each of which is independently operated upon. For example, a vectored multiply instruction may operate upon a pair of 32-bit operands, each of which is partitioned into two 16-bit sections or four 8-bit sections. Upon execution of a vectored multiply instruction, corresponding sections of each operand are independently multiplied. Fig. 1 illustrates the differences between a scalar (i.e., non-vectored) multiplication and a vector multiplication. To quickly execute vectored multiply instructions, many microprocessors use a number of multipliers in parallel. In order to conserve die space, a mechanism for reducing the number of multipliers in a microprocessor is desirable. Furthermore, a mechanism for reducing the amount of support hardware (e.g., bus lines) that may be required for each multiplier is also desirable.

Another factor that may affect the number of multipliers used within a microprocessor is the microprocessor's ability to operate upon multiple data types. Most microprocessors must support multiple data types. For example, x86 compatible microprocessors execute instructions that are defined to operate upon an integer data type and instructions that are defined to operate upon floating point data types. Floating point data can represent numbers within a much larger range than integer data. For example, a 32-bit signed integer can represent the integers between - 2³¹ and 2³¹ -1 (using two's complement format). In contrast, a 32-bit ("single precision") floating point number as defined by the Institute of Electrical and Electronic Engineers (IEEE) Standard 754 has a range (in normalized format) from 2⁻¹²⁶ to 2¹²⁷ x (2-2⁻²³) in both positive and negative numbers. While both integer and floating point data types are capable of representing positive and negative values, integers are considered to be "signed" for multiplication purposes, while floating point numbers are considered to be "unsigned." Integers are considered to be signed because they are stored in two's complement representation.

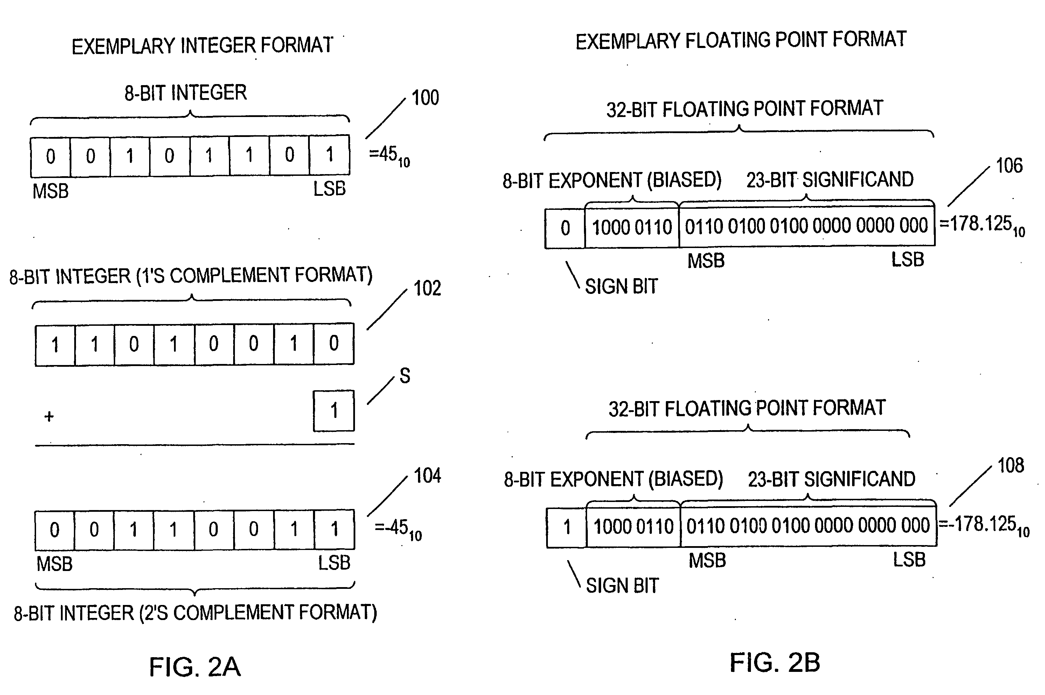

Turning now to Fig. 2A, an exemplary format for an 8-bit integer 100 is shown. As illustrated in the figure, negative integers are represented using the two's complement format 104. To negate an integer, all bits are inverted to obtain the one's complement format 102. A constant of one is then added to the least significant bit (LSB).

Turning now to Fig. 2B, an exemplary format for a 32-bit (single precision) floating point number is shown. A floating point number is represented by a significand, an exponent and a sign bit. The base for the floating point number is raised to the power of the exponent and multiplied by the significand to arrive at the number represented. In microprocessors, base 2 is typically used. The significand comprises a number of bits used to represent the most significant digits of the number. Typically, the significand comprises one bit to the left of the radix point and the remaining bits to the right of the radix point. In order to save space, the bit to the left of the radix point, known as the integer bit, is not explicitly stored. Instead, it is implied in the format of the number. Additional information regarding floating point numbers and operations performed thereon may be obtained in IEEE Standard 754. Unlike the integer representation, two's complement format is not typically used in the floating point representation. Instead, sign and magnitude form are used Thus, only the sip bit is changed when converting from a positive value 106 to a negative value 108. For this reason, many microprocessors use two multipliers, i.e., one for signed values (two's complement format) and another for unsigned values (sign and magnitude format). Thus, a mechanism for increasing floating point, integer, and vector multiplier performance while conserving die space is needed.

### SUMMARY OF THE INVENTION

The problems outlined above are in large part solved by a multiplier configured in accordance with the present invention, as defined in independent claim 1.

Further embodiments of the invention are specified in the appended dependent claims.

### BRIEF DESCRIPTION OF THE DRAWINGS

Preferred embodiments of the invention will be set out in the following detailed description and upon reference to the accompanying drawings in which:
Fig. 1 is a diagram illustrating an exemplary scalar multiplication and an exemplary vector multiplication.
Fig. 2A is a diagram of an exemplary integer data format using two's complement representation.
Fig. 2B is a diagram of an exemplary floating point data format.
Fig. 3 is a block diagram of one embodiment of an exemplary microprocessor.
Fig. 4 is a block diagram of one embodiment of the computational core from the microprocessor of Fig 3.
Fig. 5A illustrates one embodiment of the shift-and-add algorithm for binary multiplication.
Fig. 5B illustrates one embodiment of Booth's algorithm for binary multiplication.
Fig. 6 is a block diagram illustrating details of one embodiment of the multiplier from Fig. 4.
Fig. 7 is a block diagram illustrating the operation of the multiplier from Fig. 6 for unsigned operands.
Fig. 8 is a block diagram illustrating an example of the operation of the multiplier from Fig. 6 for signed operands.
Fig. 9 is a block diagram illustrating another example of the operation of the multiplier from Fig. 6 for signed operands.
Fig. 10 is a diagram illustrating one embodiment of the multiplier from Fig. 4 that is configured to perform vector multiplication.
Fig. 11A is a diagram that illustrates details of one embodiment of the partial product generator from Fig. 6.
Fig. 11B is a diagram that illustrates in detail part of one embodiment of the selection logic from Fig. 6.
Fig. 12A-B is a diagram that illustrates details of one embodiment of the selection logic and adder from Fig. 6.
Fig. 13 is a diagram illustrating another embodiment of the multiplier from Fig. 4 that is configured to perform vector multiplication.
Fig. 14 is a diagram illustrating yet another embodiment of the multiplier from Fig. 4 that is configured to perform vector multiplication.
Fig. 15 is a diagram illustrating one embodiment of a multiplier that is configured to calculate the vector dot product of a pair of vector operands.
Fig. 16 is a diagram illustrating another embodiment of a multiplier that is configured to calculate the vector dot product of a pair of vector operands.
Fig. 17 is a diagram illustrating one embodiment of a multiplier in accordance with the invention.
Fig. 18 is a diagram illustrating another embodiment of a multiplier in accordance with the invention.

### DETAILED DESCRIPTION OF AN EMBODIMENT

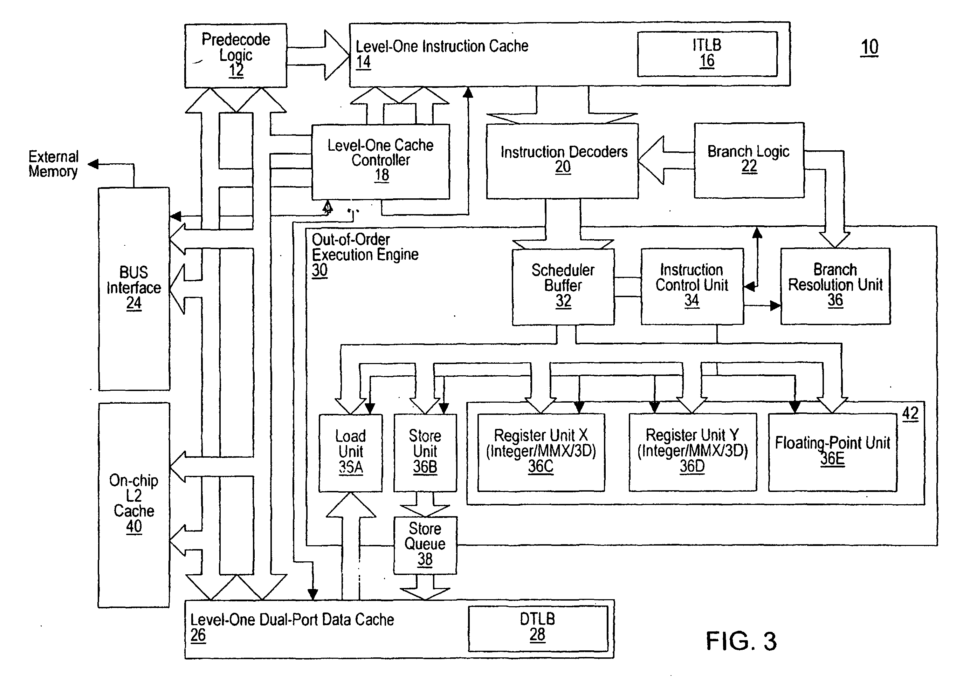

Turning now to Fig. 3, a block diagram of one embodiment of a microprocessor 10 is shown. As depicted, microprocessor 10 comprises a predecode logic block 12, a bus interface unit 24, and a level one-cache controller 18, all of which are coupled to the following three caches: a level-one instruction cache 14, a level-one data cache 26, and an on-chip level-two cache 40. Both instruction cache 14 and data cache 26 are configured with translation lookaside buffers, i.e., TLBs 16 and 28, respectively. Microprocessor 10 further comprises a decode unit 20 which receives instructions from instruction cache 14, decodes them, and then forwards them to an execution engine 30 in accordance with inputs received from a branch logic unit 22.

Execution engine 30 comprises a scheduler buffer 32, an instruction control unit 34, and a plurality of execution units 36A-36F. Note that blocks referred to herein with a reference number followed by a letter may be collectively referred to by the reference number alone. For example, execution units 36A-F may be collectively referred to as execution units 36. Scheduler buffer 32 is coupled to receive decoded instructions from decode unit 20 and convey them to execution units 36 in accordance with input received from instruction control unit 34. In one embodiment, execution units 36A-F include a load unit 36A, a store unit 36B, two integer/MMX/3D units 36C and 36D, a floating point unit 36E, and a branch resolving unit 36F. Load unit 36A receives input from data cache 26, while store unit 36B interfaces with data cache 26 via a store queue 38. Integer/MMX/3D units 36C and 36D, and floating point unit 36E collectively form a computational core 42 for microprocessor 10. Computational core 42 may further comprise other execution units and specialized hardware such as multipliers.

Before describing computational core 42 in detail, other features of microprocessor 10 will be discussed. In one embodiment, instruction cache 14 is organized into sectors, with each sector including two 32-byte cache lines. The two cache lines within each sector share a common tag but have separate state bits that indicate the status of the line. Accordingly, two forms of cache misses (and associated cache fills) may take place: (1) sector replacement and (2) cache line replacement. In the case of sector replacement, the cache miss is caused by a tag mismatch in instruction cache 14. Thus the required cache line is supplied by external memory via bus interface unit 24. The cache line within the sector that is not needed is then marked invalid. In the case of a cache line replacement, a tag matches the requested address but the corresponding cache line is marked as invalid. The required cache line is then supplied by external memory, but unlike a sector replacement, the cache line within the sector that was not requested remains unaltered. In alternate embodiments, other organizations and replacement policies for instruction cache 14 may be utilized.

In one embodiment, microprocessor 10 may be configured to perform prefetching only in the case of section replacements. During sector replacement, the required cache line is filled. If the required cache line is in the first half of the sector, the other cache line in the sector is prefetched. If the required cache line is in the second half of the sector, no prefetching is performed. Other prefetching methodologies may also be employed in different embodiments of microprocessor 10.

When cache lines of instruction data are retrieved from external memory by bus interface unit 24, the . data is conveyed to predecode logic block 12. In one embodiment, the instructions processed by microprocessor 10 and stored in cache 14 are variable-length (e.g., the x86 instruction set). Because decoding variable-length instructions is particularly complex, predecode logic 12 may be configured to provide additional information to be stored in instruction cache 14 to aid during decode. In one embodiment, predecode logic 12 generates "predecode bits" for each byte in instruction cache 14. The predecode bits may provide various information useful during the decode process, e.g., the number of bytes to the start of the next variable-length instruction. The predecode bits are passed to decode unit 20 when instruction bytes are requested from cache 14.

In one embodiment, instruction cache 14 is implemented as a 32-Kbyte, two-way set-associative, writeback cache. The cache line size may be 32 bytes in this embodiment. Cache 14 also includes a 64-entry TLB that may be used to speed linear to physical address translation. Other variations of instruction cache 14 are possible and contemplated.

Instruction cache 14 receives instruction fetch addresses from cache controller 18. In one embodiment, up to 16 bytes may be fetched from cache 14 per clock cycle. The fetched information is placed into an instruction buffer that feeds into decode unit 20. In one embodiment of microprocessor 10, fetching may occur along a single execution stream with seven outstanding branches taken. In another embodiment, fetching may take place along multiple execution streams.

In one embodiment, the instruction fetch logic within cache controller 18 is capable of retrieving any 16 contiguous instruction bytes within a 32-byte boundary of cache 14 with no additional penalty when the 16 bytes cross a cache line boundary. New instructions are loaded into the instruction buffer as the current instructions are consumed by decode unit 20. Other configurations of cache controller 18 are also possible and contemplated.

In one embodiment, decode logic 20 may be configured to decode multiple instructions per processor clock cycle. Decode unit 20 may further be configured to accept instruction and predecode bytes from the instruction buffer (in x86 format), locate actual instruction boundaries, and generates corresponding "RISC ops". RISC ops are fixed-format internal instructions, most of which are executable by microprocessor 10 in a single clock cycle. In one embodiment of microprocessor 10, RISC ops are combined to form every function in the x86 instruction set. Microprocessor 10 may use a combination of decoders to convert x86 instructions into RISC ops. In one embodiment, the hardware comprises three sets of decoders: two parallel short decoders, one long decoder, and one vector decoder. The parallel short decoders translate the most commonly-used x86 instructions (e.g., moves, shifts, branches, etc.) into zero, one, or two RISC ops each. The short decoders only operate on x86 instructions that are up to seven bytes long. In addition, they are configured to decode up to two x86 instructions per clock cycle. Commonly-used x86 instructions which are greater than seven bytes long, as well as those semi-commonly-used instructions that are up to seven bytes long, are handled by the long decoder.

The long decoder in decode unit 20 only performs one decode per clock cycle generating up to four -RISC ops. All other translations (complex instructions, interrupts, etc.) are handled by a combination of the vector decoder and an on-chip ROM. For complex operations, the vector decoder logic provides the first set of RISC ops and an initial address to a sequence of further RISC ops within the on-chip ROM. The RISC ops fetched from the on-chip ROM are of the same type that are generated by the hardware decoders.

In one embodiment, decode unit 20 generates a group of four RISC ops each clock cycle. For clock cycles in which four RISC ops cannot be generated, decode unit 20 places RISC NOP operations in the remaining slots of the grouping. These groupings of RISC ops (and possible NOPs) are then conveyed to scheduler buffer 32. It is noted that in other embodiments, microprocessor 10 may be configured to decode other instructions sets in place of, or in addition to, the x86 instruction set.

Instruction control logic 34 contains the logic necessary to manage out-of-order execution of instructions stored in scheduler buffer 32. Instruction control logic 34 also manages data forwarding, register renaming, simultaneous issue and retirement of RISC ops, and speculative execution. In one embodiment, scheduler buffer 32 holds up to 24 RISC ops at one time, which is equivalent to a maximum of twelve x86 instructions. When possible, instruction control logic 34 may simultaneously issue (from buffer 32) RISC ops to any available execution units 36. In one embodiment, control logic 34 may be configured to issue up to six and retire up to four RISC ops per clock cycle.

In one embodiment, store unit 36A and load unit 36B may each have two-stage pipelines. Store unit 36A may be configured to perform memory and register writes such that the data is available for loading after one clock cycle. Similarly, load unit 36B may be configured to perform memory reads such that the data is available after two clock cycles. Other configurations for load and store units 36A and 36B are also possible with varying latencies.

Execution unit 36G (the branch resolving unit) is separate from branch prediction logic 22 in that it resolves conditional branches such as JCC and LOOP after the branch condition has been evaluated. Branch resolving unit 36G allows efficient speculative execution, enabling microprocessor 10 to execute instructions beyond conditional branches before knowing whether the branch prediction was correct. As described above, microprocessor 10 may be configured to handle up to seven outstanding branches in one embodiment.

Branch prediction logic 22, coupled to decode unit 20, is configured to increase the accuracy with which conditional branches are predicted in microprocessor 10. Ten to twenty percent of the instructions in typical applications include conditional branches. Branch prediction logic 22 is configured to handle this type of program behavior and its negative effects on instruction execution, such as stalls due to delayed instruction fetching. In one embodiment, branch prediction logic 22 includes an 8192-entry branch history table, a 16-entry by 16 byte branch target cache, and a 16-entry return address stack. Branch prediction logic 22 may implement a two-level adaptive history algorithm using the branch history table. The table stores executed branch information, predicts individual branches, and predicts behavior of groups of branches. In one embodiment, the branch history table does not store predicted target addresses in order to save space. Instead, the addresses are calculated on-the-fly during the decode stage.

To avoid a clock cycle penalty for a cache fetch when a branch is predicted taken, a branch target cache within branch logic 22 supplies the first 16 bytes at that address directly to the instruction buffer (assuming a hit occurs in the branch target cache). In one embodiment, branch prediction logic 22 achieves branch prediction rates of over 95%.

Branch logic 22 may also include special circuitry designed to optimize the CALL and RET instructions. This circuitry allows the address of the next instruction following the CALL instruction in memory to be pushed onto a return address stack. When microprocessor 10 encounters a RET instruction, branch logic 22 pops this address from the return stack and begins fetching.

Like instruction cache 14, data cache 26 may also be organized as two-way set associative 32-Kbyte storage. In one embodiment, data TLB 28 includes 128 entries that may be used to translate linear to physical addresses. Like instruction cache 14, data cache 26 may also be sectored. Data cache 26 may further implement a MESI (modified-exclusive-shared-invalid) protocol to track cache line status. Other configurations of data cache 26 are also possible and are contemplated.

### Computational Core

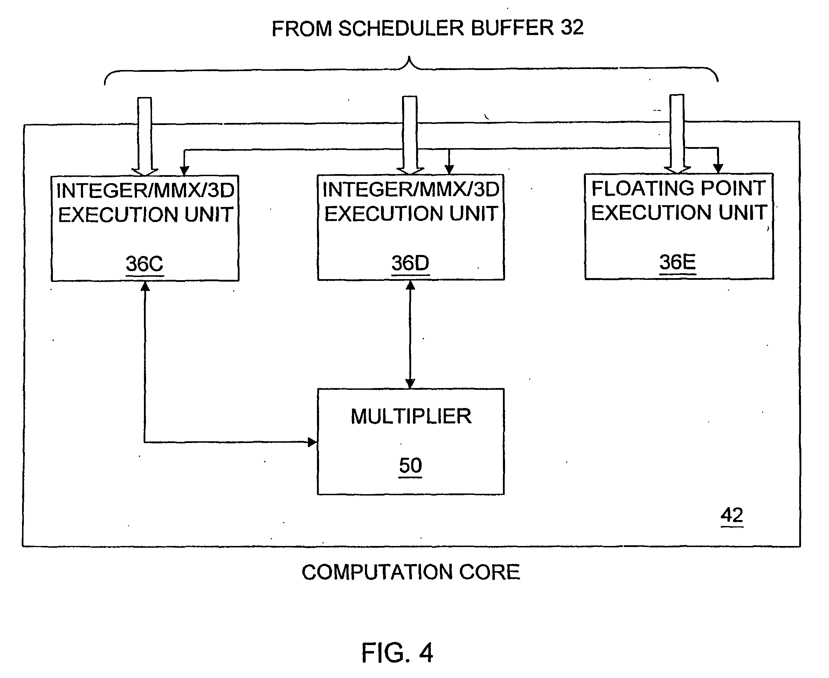

Turning now to Fig. 4, more detail of one embodiment of computation core 42 is shown. In one embodiment, computation core 42 comprises three execution units 36C-E and a multiplier 50. Integer/MMX/3D execution unit 36C is a fixed point execution unit which is configured to operate on all ALU operations, as well as multiplies, divides (both signed and unsigned), shifts, and rotates. In contrast, integer/MMX/3D execution unit 36E (Integer Y unit) is a fixed point execution unit configured to operate only on the basic word and doubleword ALU operations (ADD, AND, CMP, etc.).

Execution units 36C and 36D are also configured to accelerate performance of software written using multimedia and 3D graphics instructions. Applications that can take advantage of multimedia and 3D graphics instructions include 3D modeling and rendering, video and audio compression/decompression, speech recognition, and telephony. Execution units 36C and 36D may be configured to execute multimedia instructions in a single clock cycle. Many of these instructions are designed to perform the same operation to multiple sets of data at once (i.e., vector processing). In one embodiment, execution units 36C and 36D use registers which are mapped onto the stack of floating point unit 36E.

Execution unit 36E contains an IEEE 754-compatible floating point unit designed to accelerate the performance of software which utilizes the x86 instruction set. Floating point software is typically written to manipulate numbers that are either very large or small, require a great deal of precision, or result from complex mathematical operations such as transcendentals. Floating point execution unit 36E may comprise an adder unit, a multiply unit, and a divide/square root unit. In one embodiment, these low-latency units are configured to execute floating point instructions in as few as two clock cycles.

In one embodiment, execution units 36C and 36D are coupled to multiplier 50 and are configured to utilize multiplier 50 as a shared resource. Advantageously, this configuration allows both execution units 36C and 36D to perform multiplication without requiring two multipliers. In another configuration, each execution unit 36C and 36D may each have their own dedicated multiplier. Still other configurations are possible and contemplated. For example, two n-bit multipliers may be shared by execution units 36C and 36D. Configuring microprocessor 10 with two multipliers each having a width of 32-bits advantageously allows two single precision multiplications to be executed in parallel (each operand/significand is 24 bits wide), or one MMX packed multiply (i.e., multiplying a pair of vectors wherein each vector comprises four 16-bit components). In another embodiment, multiplier 50 may be configured to accept operands that are 76-bits wide (i.e., the width of the significand in a double precision floating point data type), thereby providing the same functionality as two separate 32-bit multipliers while further alleviating the need for a separate multiplier in floating point unit 36E. In such an embodiment, execution units 36C-36E may be directly coupled to multiplier 50, with each execution unit sharing multiplier 50.

Multiplier 50 may also be configured to perform both signed and unsigned multiplication. Advantageously, this allows multiplier 50 to support both integer multiplication for MMX instructions, and floating point multiplication for 3D graphics instructions.

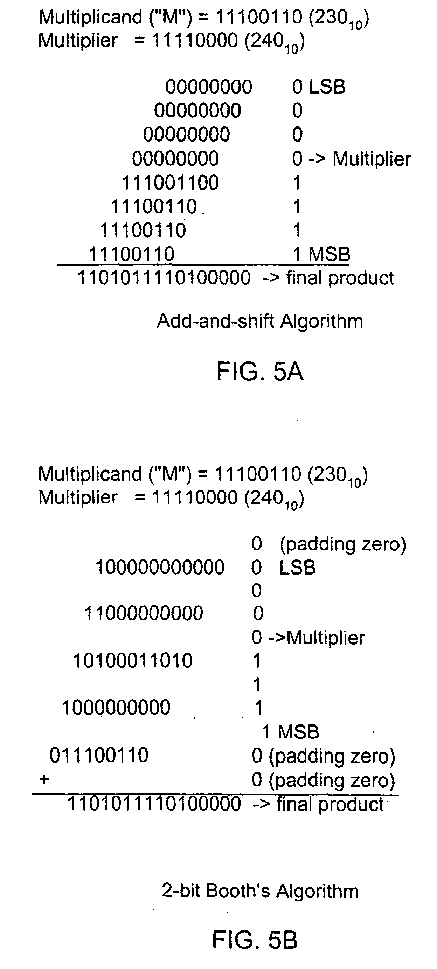

While multiplier 50 may be configured to perform multiplication using a number of different algorithms, the embodiment shown in the figure is configured to use a modified version of Booth's Algorithm to improve multiplication times. Booth's algorithm relies upon calculating a number of partial products and then summing them to obtain a final product. Booth's algorithm is able to improve multiplication times over the standard "add-and-shift" algorithm by reducing the number of partial products that need to be sumned in order to obtain the final product For example, in performing an 8-bit by 8-bit multiplication, the shift-and-add algorithm generates eight partial products. By contrast, same 8-bit by 8-bit multiplication using the 2-bit version of Booth's algorithm generates only five partial products. This reduction in the number of partial products is illustrated in Figs. 5A and 5B.

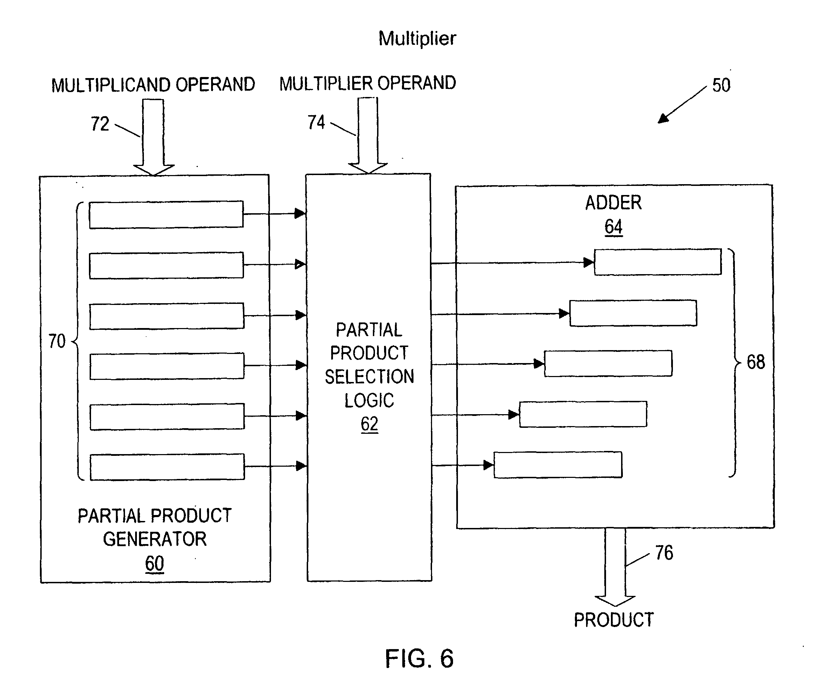

Turning now to Fig. 6, more detail of one embodiment of multiplier 50 is shown. In this embodiment, multiplier 50 comprises a partial product generator 60, a partial product selection logic unit 62, and an adder 64. As shown in the figure, partial product generator 60 is coupled to selection logic unit 62, which is in turn coupled to adder 64. When one of execution units 36C-36E receives an instruction invoking the multiplication function, the execution unit conveys two operands to multiplier 50, i.e., a multiplicand operand 72 and a multiplier operand 74. Partial product generator 60 is coupled to receive multiplicand operand 72, which is used as a starting value for calculating a plurality of partial products 70. For example, if partial product generator 60 is configured to use the 2-bit version of Booth's algorithm, the following partial products would be generated: the multiplicand itself ("+M"), a shifted version of the multiplicand ("+2M"), an inverted version of the multiplicand ("-M"), a shifted and inverted version of the multiplicand ("-2M"), and two constants, i.e., a positive zero ("+0") and a negative zero ("-0") in two's complement form.

Partial product selection unit 62 is coupled to receive multiplier operand 74. Selection unit 62 is configured to select a number of partial products from generator 60 based upon particular fields within multiplier operand 74. For example, using the 2-bit version of Booth's algorithm, multiplier operand 74 is padded with leading and trailing zeros (assuming an unsigned multiplication is being performed), and then one partial product is selected by each 3-bit field within the operand.

Finally, adder 64 is configured to receive and sum the partial products selected by selection unit 62. As noted in the figure, the selected partial products 68 are shifted before they are summed. The resulting final product 76 is output to the execution unit that transmitted the operands. As previously noted, multiplier 50 may advantageously be configured to perform both signed and unsigned multiplication. This is described in greater detail below.

### Scalar Unsigned Multiplication

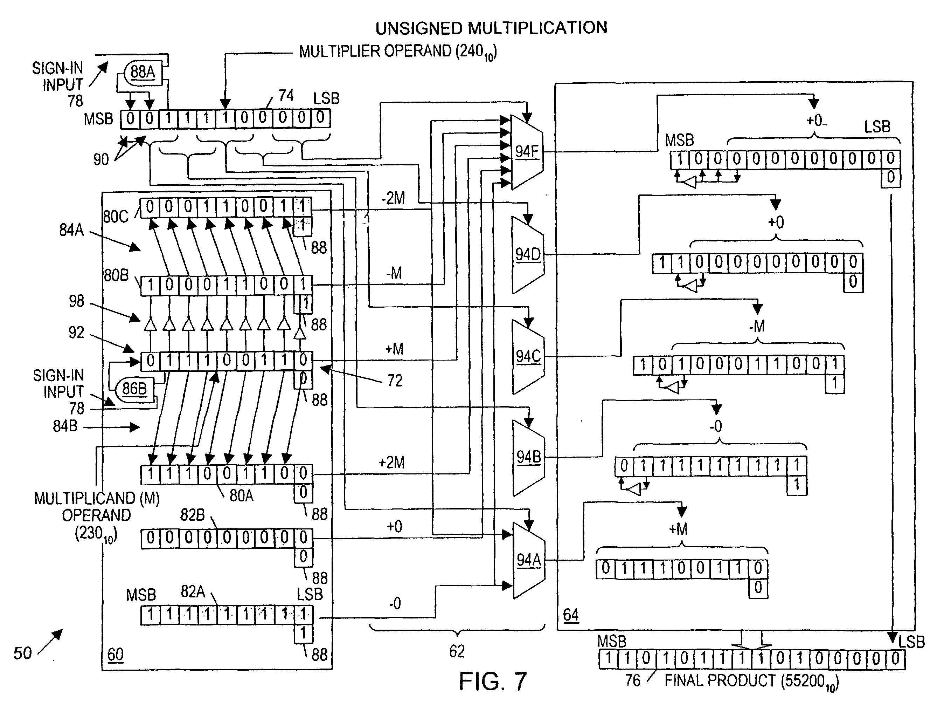

Turning now to Fig. 7, details of one embodiment of multiplier 50 are shown. The figure also illustrates the operation of multiplier 50 for an unsigned multiplication. While the figure shows an 8-bit by 8-bit multiplier using the 2-bit version of Booth's algorithm, other configurations are possible and contemplated, e.g., a 32-bit by 32-bit multiplier using 3-bit version of Booth's algorithm. In this embodiment, multiplier 50 further comprises a "sign-in" input 78, which indicates whether a signed or unsigned multiplication is to be performed. Sign-in input 78 is coupled to AND gate 86A, which also receives the most significant bit ("MSB") of multiplier operand 74. AND gate 86A outputs an "effective sign" bit 90 for multiplier operand 74 which is copied and appended to multiplier operand 74 for use by selection logic unit 62. Sign-in input 78 is also routed to AND gate 86B, which similarly calculates and appends an effective sign bit 92 for multiplicand operand 72, While other effective sign calculation logic may be used, the configuration illustrated advantageously generates an effective sign of zero for all unsigned operands and positive signed operands using a minimum amount of logic. Furthermore, in the embodiment shown only signed negative operands receive an asserted effective sign bit.

Partial product generation logic 60 uses multiplicand operand 72 and effective sign bit 92 to generate a number of partial products 80A-80C. For example, a shifted version 80A of multiplicand operand 72 is generated by shifting logic 84B. Shifted version 80A is equivalent to two times the multiplicand operand (+2M). Similarly, inverters 98 generate an inverted (i.e., one's complement) version (-M) of multiplicand operand 72. Shifting logic 84A is used to generate a shifted and inverted version 80C (-2M) of multiplicand operand 72. Partial product generation logic 60 also generates constants for use as partial products, e.g., positive zero 82B (+0) and negative zero 82A (-0). As illustrated in the figure, each partial product 80A, 80B, 80C, 72, 82A, and 82B may have an extra constant bit 88 associated with it. Extra constant bit 88 is asserted only for negative partial products, i.e., -M, -2M, and -0, and is added to the partial product within adder 64 to generate two's complement versions of the inverted partial products. The shaded areas of the figure denote constants that may be designed into multiplier 50.

Once partial product generator 60 has generated the partial products, selection logic 62 is configured to select partial products based upon 3-bit fields from multiplier operand 74. Multiplier operand 74 is padded with zeros and copies of effective sign bit 90 so that there are no fractional 3-bit fields. Selection logic 62 may comprise a number of multiplexers 94A-94F, one for each partial product to be selected. Each multiplexer 94A-94E is controlled by a different 3-bit field from multiplier operand 74. The 3-bit fields determine which partial product from those generated by partial product generator 60, i.e., +M, +2M, -M, -2M, +0, -0, will be selected. The selected partial products are then conveyed to adder 64. Using 2-bit Booth decoding, Table 1 describes how partial products will be selected.

**Table 1.**

| 3-bit Multiplier Field Value | Partial Product Selected |
|---|---|
| 000 | +0 |
| 001 | +M |
| 010 | +M |
| 011 | +2M |
| 100 | -2M |
| 101 | -M |
| 110 | -M |
| 111 | -0 |

Adder 64 is configured to receive and sum the selected partial products. As illustrated in the figure, the partial products are shifted before being summed. Some of the partial products may have prefix bits added to eliminate the need for sign extending the partial product's most significant bit (i.e., sign bit) to the maximum width of final product 76. The prefixes may be generated using simple inverters coupled to the partial product's most significant bit and constants. Once the partial products are shifted, padded, and summed, final product 76 is output and conveyed to the execution unit that provided the operands. Adder 64 may use a number of different algorithms for summing the partial products. For example, adder 64 may configured as a carry look-ahead adder, a carry skip adder, a carry select adder, a carry-save adder, or a carry propagate adder.

The exemplary values in the figure illustrate the unsigned multiplication of two values, 240₁₀ and 230₁₀. Sign-in input 78 is unasserted because unsigned multiplication to be performed. Sign-in input 78 may be provided by the same execution unit that provided the operands. The execution unit may generate sign-in input bit 78 based upon the type of multiply instruction it received. In the example shown in the figure, effective signs 90 and 92 are both zero because sign-in input 78 is unasserted. As shown in the illustration, an 8-bit by 8-bit version of multiplier 50 is able to multiply 8-bit unsigned operands (i.e., operands that do not have a sign bit) having values from 0 to 255 to obtain a 16-bit unsigned result.

### Scalar Signed Multiplication

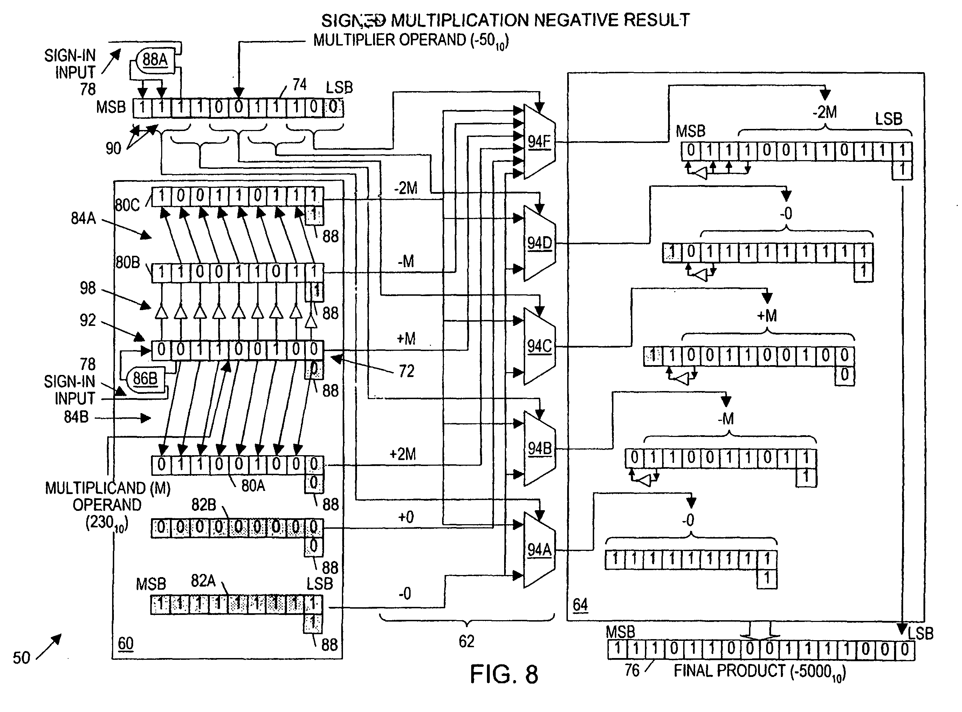

Turning now to Fig. 8, the same 8-bit by 8-bit version of multiplier 50 is shown. In this figure, however, multiplier 50 is performing signed multiplication. Sign-in input 78 is asserted because signed multiplication is to be performed. In the example illustrated, multiplicand operand 72 equals 100₁₀, while multiplier operand 74 equals -50₁₀. Multiplier operand 74 is received in two's complement format because it is a negative signed value. Thus its effective sign bit 90 (as calculated by AND gate 88A) is asserted. In contrast, effective sign bit 92 for multiplicand operand 72 is unasserted because multiplicand operand 72 is positive. The final product 76 is a negative 16-bit number (-5000₁₀) represented in two's complement format with the MSB indicating the sign.

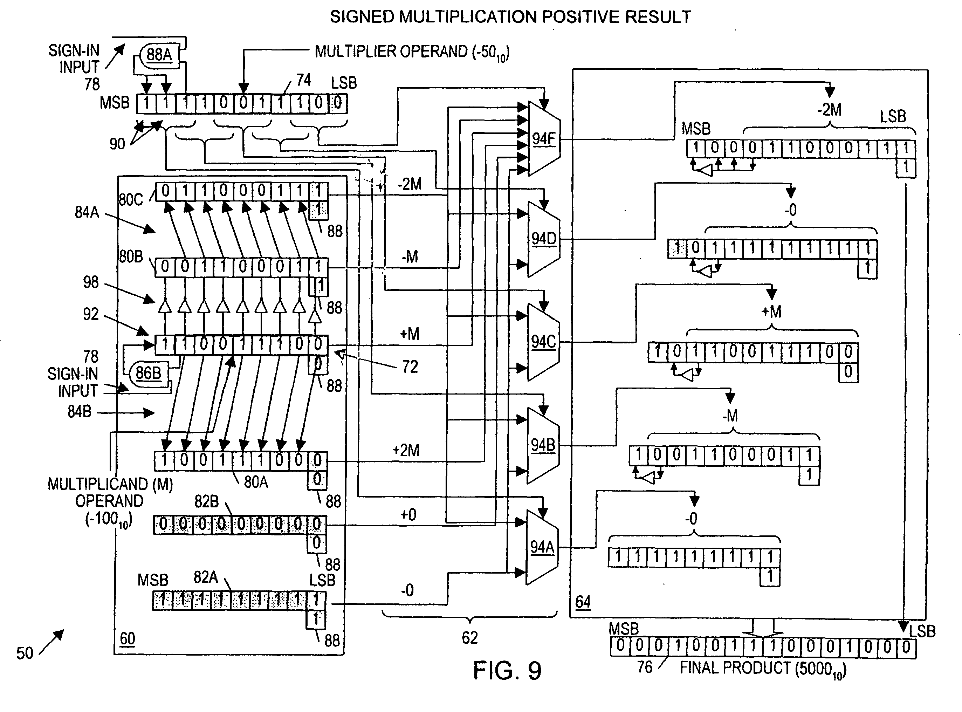

Turning now to Fig. 9, another example of multiplier 50 performing a signed multiplication is shown. In this example, however, both multiplier operand 74 (having a value of-50₁₀) and multiplicand operand 72 (having a value of -100₁₀) are received in two's complement format. The multiplication results in a signed final product 76 (having a value of 5000₁₀) that is positive. As Figs. 6-8 illustrate, multiplier 50 may advantageously perform both signed and unsigned multiplication with the same hardware. Furthermore, multiplier 50 may advantageously be configured to use Booth's algorithm to further increase multiplication performance.

### Component-wise Vector Multiplication

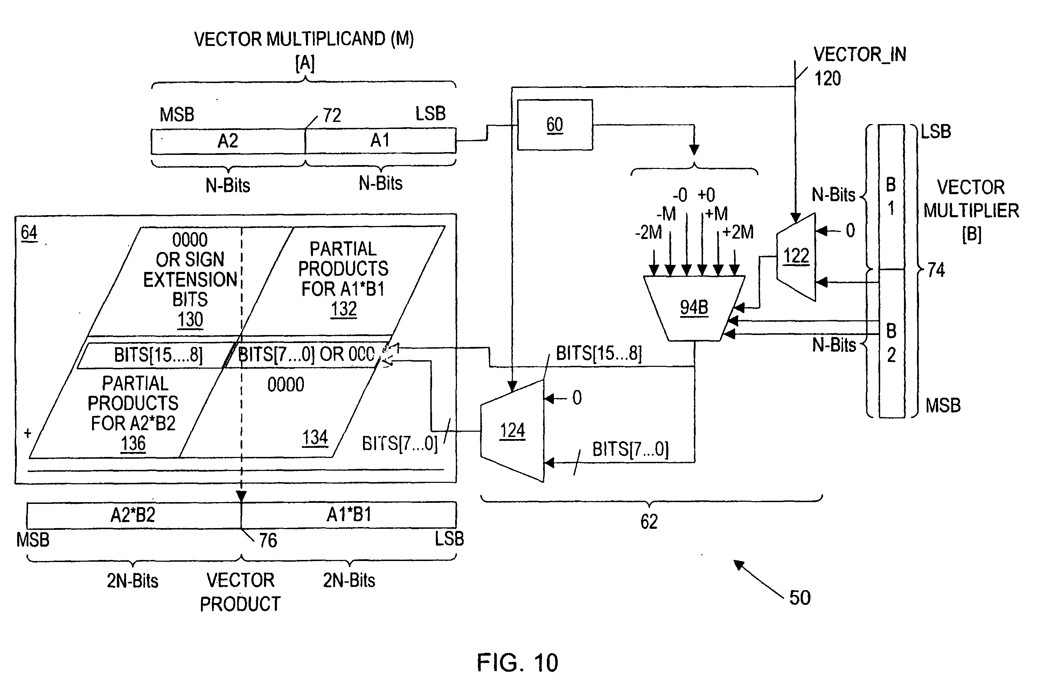

As previously noted, recent advances have placed a greater emphasis on microprocessors' multimedia and graphics performance. Multimedia and 3D extensions to the basic x86 instruction set include vectored multiply instructions to improve performance. Turning now to Fig. 10, an embodiment of multiplier 50 capable of performing vector multiplication is shown. As in previous embodiments, multiplier 50 comprises partial product generator 60, selection logic 62, and adder 64. This embodiment of multiplier 50 is configured to perform component-wise vector multiplication of two pairs of N-bit values (A1×B1 and A2×B2) simultaneously or a scalar multiplication of one pair of 2N-bit values (A×B). Advantageously, multiplier 50 may take the place of three separate multipliers (i.e., one for scalar multiplication and two for the vector multiplication), thereby saving valuable die space.

In this embodiment, multiplier 50 has several features which allow it to perform both scalar and component-wise vector multiplication. When scalar multiplication is performed, multiplier 50 functions as previously disclosed, i.e., adder 64 will sum the partial products selected by selection logic 62 from partial product generator 60 to form final product 76. When performing component-wise vector multiplication, however, multiplier 50 is configured to effectively operate as two separate multipliers. This behavior ensures that the results generated by multiplier 50 will equal the results that would have been generated had two separate multipliers been used. To indicate whether multiplier 50 should perform component-wise vector multiplication or scalar multiplication, multiplier 50 receives a vector_in input signal 120. When an asserted vector_in signal is received, a plurality of multiplexers within selection logic 62 (e.g., multiplexers 122 and 124) effectively isolate the two "logical halves" of multiplier 50. This separation prevents partial products from one pair of vector components (e.g., A1 and B1) from interfering with the multiplication of another pair of vector components (e.g., A2 and B2). The operation of multiplexers 122 and 124 is described in greater detail below.

As shown in the figure, multiplicand operand 72 and multiplier operand 74 may each comprise a vector (two N-bit values) or a scalar value (a single 2N-bit value). For example, multiplicand operand 72 may comprise a vector (A2, A1) or a single scalar value A. The partial products selected by selection logic 62 may be logically divided into four quadrants 130-136 for component-wise vector multiplications (assuming vector operands each having two vector components). Quadrant 130 represents the higher order bits of partial products selected by the least significant vector component of vector multiplier 74 (i.e., B1). Quadrant 132 represents the lower order bits of partial products selected by the least significant vector component of vector multiplier 74 (i.e., B1). Quadrant 134 represents the lower order bits of partial products selected by the most significant vector component of vector multiplier 74 (i.e., B2). Quadrant 136 represents the higher order bits of partial products selected by the most significant vector component of vector multiplier 74 (i.e., B2).

As the selected partial products are shifted before being summed in adder 64, the least significant bits of partial products selected by vector component B2 located within quadrant 134 may affect the addition performed to generate A1×B1 within final product 76. To prevent this "corruption" of final product 76, multiplexer 124 is configured to "zero-out" the lower order bits of partial products located within quadrant 134. Similarly, in some embodiments the higher order bits of partial products selected by vector component B1 may extend into quadrant 130, thereby possibly affecting the summation used to form B1×B2 within final product 76. Thus additional multiplexers similar to multiplexer 124 may be used to zero-out the higher order bits within quadrant 130.

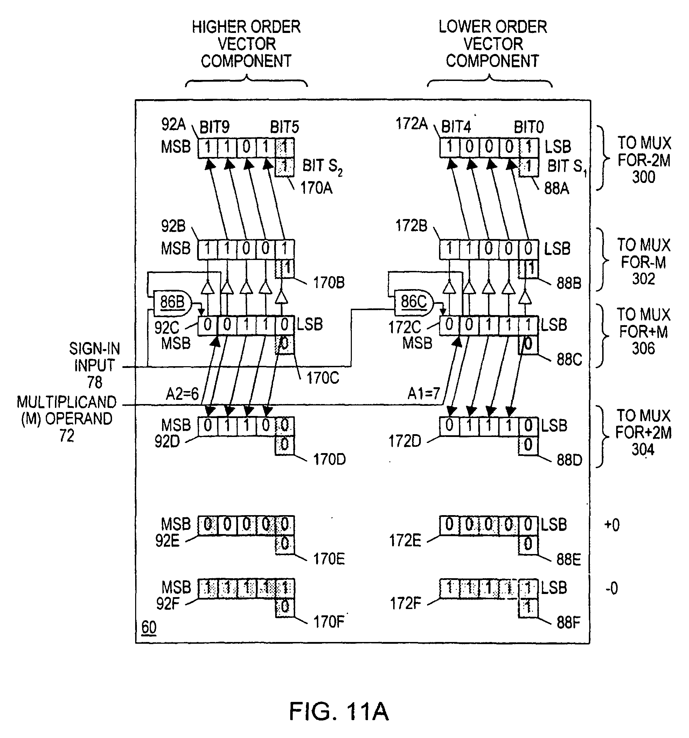

Multiplexer 122 also assists in the logical separation that is advantageous for component-wise vector multiplication. Staggered bit fields within multiplier operand 74 are used to select partial products from partial product geneator 60. When a bit field encompasses bits from more than one vector component within multiplier operand 74, the resulting partial product may also be "corrupted." For example, selecting a partial product using one bit from vector component B1 and two bits from vector component B2 (as illustrated in the figure) will result in a partial product that is partially representative of vector component B1 and partially representative of vector component B2. This is undesirable because B1 is to be multiplied with A1 separately from B2. To remedy this, a multiplexer 122 may be used. When a bit field encompasses bits from more than one vector component, multiplexer 122 may zero-out the unwanted bit or bits (e.g., the most significant bit from B1 as shown in the figure). Thus, the partial product selected by multiplexer 94B will reflect only the bit values within the desired vector component. A second multiplexer similar to multiplexer 122 may zero out the opposite bits. Thus two partial products may be selected, one representing the end of vector operand B1 and one representing the beginning of vector operand B2. The zeroing-out of bits for partial product selection and summation are illustrated in more detail by way of a numerical example in Figs. 11A through 12.

Turning now to Fig. 11A, more detail of one embodiment of partial product generator 60 is shown. To support component-wise vector multiplication when the vector components are signed, an additional effective sign bit 172A-172F may be generated for the lower-order portion of each partial product. The same logic may be used as previously disclosed, with AND-gate 86B being duplicated (see AND-gate 86C) to generate an effective sign for each lower-order vector component. Advantageously, multiplier 50 may be configured to perform both signed and unsigned vector multiplication. Generator 60 may also be configured to generate separate constant bits 88A-F (referred to as S1) and 170A-F (referred to as S2) to further improve separability when the selected partial products are summed in adder 64. The extra constant bits 170A-F and effective sign bits 172A-F may simply remain unused or unselected during scalar multiplication. Note the figure illustrates one possible set of partial products generated for an unsigned component-wise vector multiplication wherein the multiplicand operand 72 has the values of (6,7), i.e., A2=6 and A1=7. Sign_in input 78 is unasserted to indicate that an unsigned multiplication is being performed.

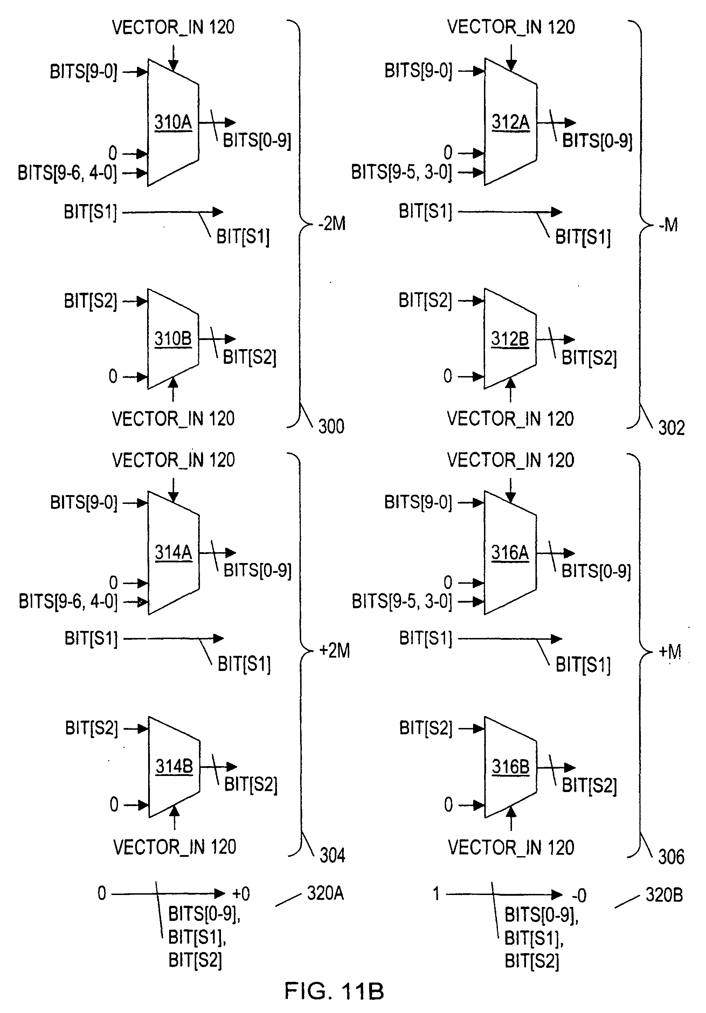

Turning now to Fig. 11B, detail of part of one embodiment of selection logic 62 is shown. In order to support both scalar and vector multiplication. selection logic 62 may comprise a plurality of multiplexers 310A-B, 312A-B, 314A-B, and 316A-B. These multiplexers operate to select particular bits from partial product generator 60 according to the status of vector_in signal 120. Each partial product has its own set of selection multiplexers (excluding constants +0 and -0 which are simply fed through as is; see 320A and 320B). For example, multiplexer 310A selects bits [9-0] from the partial product -2M and outputs them to the rest of selection logic 62 and adder 64 if vector_in is asserted. This may ensure that both effective sign bits 92A and 172A are conveyed to adder 64. Two effective sign bits are needed because two separate multiplications are being performed. Conversely, if vector_in is unasserted (indicating a scalar multiplication), extra effective sign bit 172A is not needed, thus multiplexer 310A selects bits [9-6, 4-0] and outputs them as bits [0-8]. The extra effective sign bit 172A is removed, and a constant zero is padded to the output to create bit [9]. As indicated in the figure, bit [S1] may be passed through as it is needed in both cases (scalar and component-wise vector multiplication). Multiplexer 310B selects bit [S2] if vector_in signal 10 is asserted, thereby providing two constants 88A and 170A. If vector_in signal 120 is not asserted and scalar multiplication is being performed, bit [S2] is not needed (and may cause an incorrect result if it is passed through to adder 64). Thus, multiplexer 310B is configured to select and convey a constant zero in place of actual S2 bit 170A if scalar multiplication is performed. Multiplexers 312A-B, 314A-B, and 316A-B operate in a similar fashion. Each multiplexer may be configured to select the required bits from partial product generator 60 without passing extra bits unless they are needed.

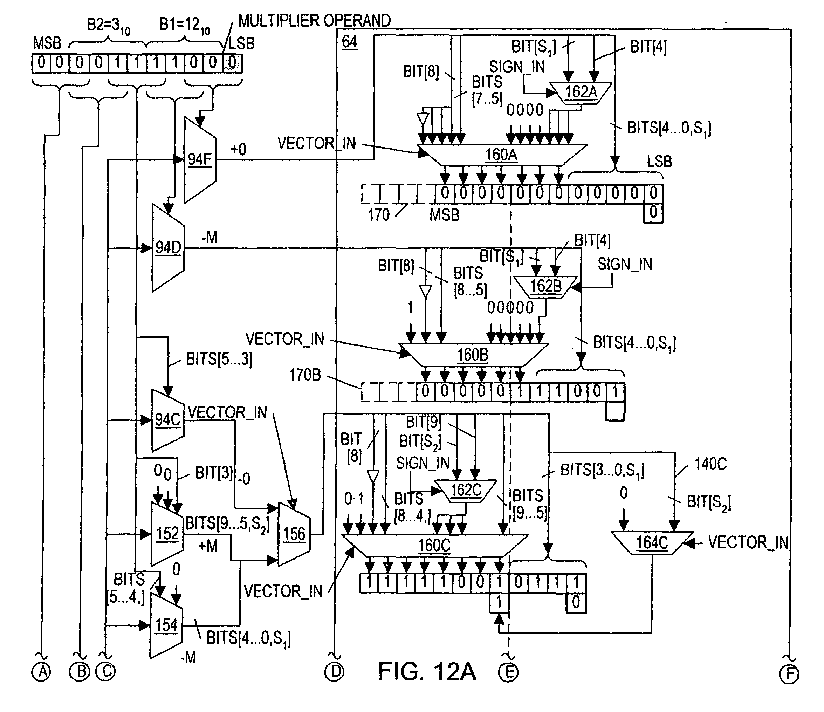

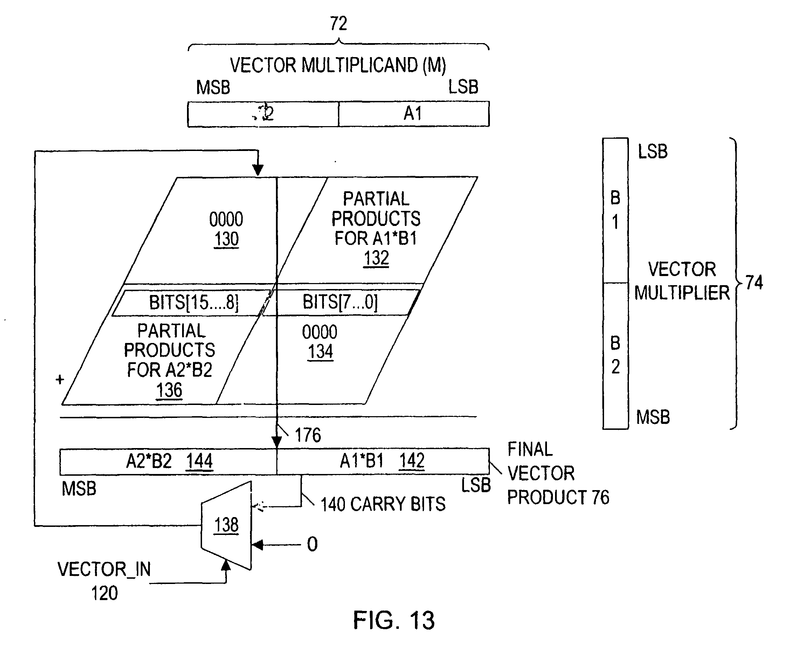

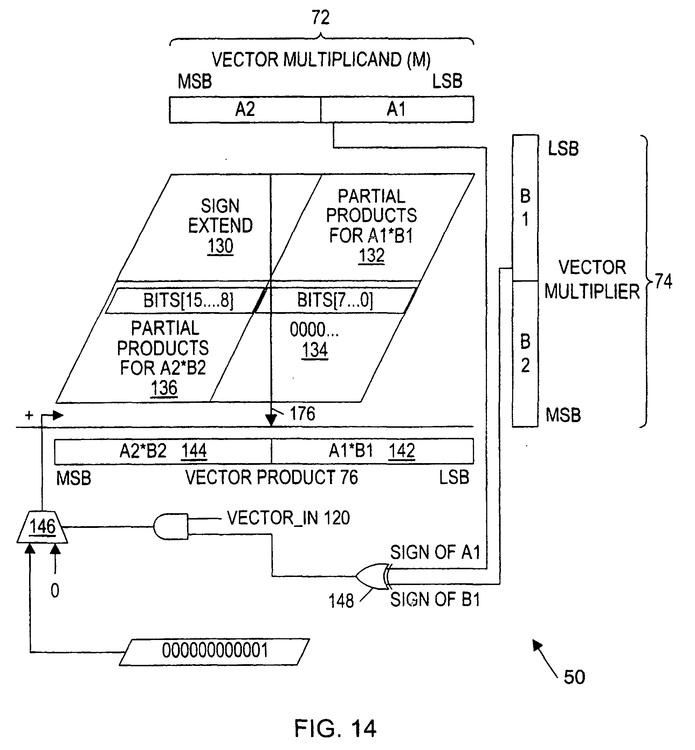

Turning now to Fig. 12A-B, more details of one embodiment of selection logic 62 and adder 64 are shown. In this embodiment, selection logic 62 comprises a plurality of multiplexers 94A-94F as in the previous embodiments. Note that multiplexers 312A-B, 314A-B, and 316A-B are not shown, but are instead included within partial product generator 60. Selection logic 62 further comprises multiplexers 152-156, which operate to select two portions of partial products: (1) a portion of the partial product corresponding to the higher order bits of vector operand B1, and (2) a portion of the partial product corresponding to the lower order bits of vector operand B2. Multiplexer 156 then selects this "combination" partial product when vector_in signal 120 is asserted. Advantageously, this configuration may remedy the problem of summation corruption when a bit field encompassing bits from more than one vector operand is used to select a partial product. This problem is described in greater detail below (see Figs. 13 and 14).

In this embodiment, adder 64 comprises three pluralities of multiplexers 160A-160D, 162A-162E, and 164C-164E. Multiplexers 160A-160D are controlled by vector_in signal 120 and operate to "zero-out" portions of the partial products to prevent corruption of the vector components within final product 76 during the summation within adder 64. Multiplexers 164C-E are also controlled by vector_in signal 120 and operate to select either extra constant bits 140C-140E (in the event of a vector multiplication) or a zero constant (in the event of a scalar multiplication) for addition into the more significant product. Multiplexers 162A-162D are controlled by sign_in input 78 and are configured to select either the effective sign bit of the more significant portion of the selected partial product (in the event of a signed vector multiplication) or the actual sign (in the event of an unsigned vector multiplication). Multiplexers 164C-164E are also controlled by vector_in signal 102 and perform the same function as multiplexers 310B, 312B, 314B, and 316B, i.e., they select a constant zero instead of extra constant bit S2 if scalar multiplication is performed. Note that other configurations of logic for zeroing out and partial product selection are possible and contemplated. Further note that multiplexers 160A-160D, 162A-162E, and 164C-164E may be configured as part of adder 64, selection logic unit 62, or as a separate part of multiplier 50.

In addition to the features disclosed above, adder 64 may further comprise a plurality of multiplexers (not shown) to prevent carries across the boundaries of vector operands within final product 76 when summing the selected partial products. This boundary is represented by a dashed line 178 in the figure. Other embodiments of multiplier 50 may utilize different configurations of multiplexers. For example, multiplexers 160A-160C may be configured to select either additional sign-extension bits or the most significant bits of the selected partial products. In addition, multiplexers 160A-160C may be configured to pad each selected partial product with prefix bits until the most significant bit of each selected product corresponds to the most significant bit of final product 76 (as indicated by dashed bit positions 170A-170B). The prefix bits may comprise a constant, sign extension bits. or a combination thereof.

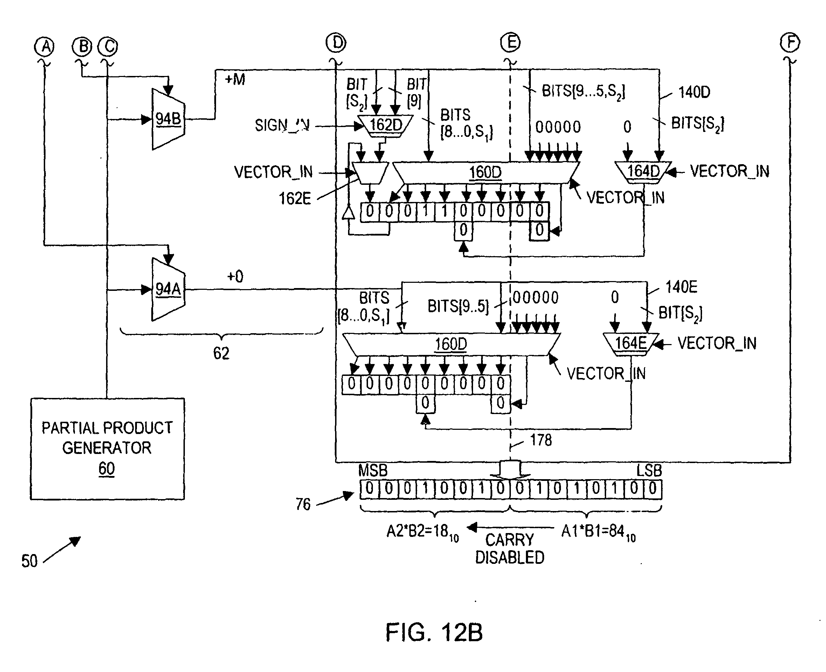

Note that Figs. 11A-B and 12 together illustrate the exemplary component-wise multiplication of two vector operands, i.e., multiplier operand 74 having a value of (3,12), i.e., B2=3 and B1=12, arid multiplicand operand 72 having a value of (6,7), i.e., A2=6, and A1=7, resulting in final product 76 having a value of (18,84). Further note that while the figures and exemplary embodiments have illustrated a multiplier configured to perform component-wise vector multiplication on vector operands having up to two vector components, other configurations are possible and contemplated, e.g. vectors having four or six vector components may be multiplied component-wise in parallel. Furthermore, a number of multipliers configured similarly to multiplier 50 may be used in parallel to achieve even higher performance. The widths of multiplier operand 74 and multiplicand operand 72 may also be varied, e.g., 32-bits or 64-bits, as may the widths of their vector components.

In addition, other embodiments of multiplier 50 may be configured to return only a portion of final product 76 per clock cycle. For example, the most significant vector component of final product 76 may be returned during a first clock cycle. Other vector components may be returned during subsequent clock cycles in order of their significance.

Turning now to Fig. 13, another embodiment of multiplier 50 is shown. In this embodiment, multiplier 50 further comprises multiplexer 138. When vector_in signal 120 is asserted, component-wise vector multiplication is performed. If the summing of partial products generates one or more carry bits 140, the upper vector component in final product 144 may be corrupted if carry bits 140 are allowed to propagate across boundary 176. To prevent this, multiplier 50 may comprise one or more carry multiplexers 138 to prevent carry bits from propagating to higher order vector components within final product 76. When multiplier 50 is performing scalar multiplication, multiplexers 138 may be configured to propagate carry bits normally. As shown in the figure, in this embodiment of multiplier 50 the partial products in quadrant 130 are zeroed out such that they will not affect the value of final product 144.

Turning now to Fig. 14, another embodiment of multiplier 50 is shown. In this embodiment, the partial products in quadrant 130 are not zeroed out. Instead, the selected partial products in quadrant 132 are allowed to sign extend across quadrant 130. In some instances, e.g., when vector components A1 and B1 have opposite signs, final product 76 will have a lower order vector component 142 that will be negative and may result in a sign extensions across quadrant 130. This sign extension may affect the value of the more significant vector component 144 within final product 76. Multiplexer 146 is configured to insert a constant to be summed with the selected partial products to form final product vector component 144. The constant (e.g., a binary value of one) is calculated to compensate for a negative sign extension across final product 144. For example, a negative sign extension may be equivalent to "11111111," thus adding a constant of one (i.e., "00000001") will negate the effect of the sign extension on result vector component 144. As this sign extension occurs only when vector components A1 and B1 have different signs, an XOR-gate 148 may be used in conjunction with vector_in input 120 to control multiplexer 146 so that the constant is only added when final product 142 will be negative and a component-wise vector multiplication is being performed. As illustrated, XOR-gate 148 may receive the sign bits (i.e., the most significant bits) of vector components A1 and B1 as inputs.

### Vector Dot Product

Multiplier 50 may also be configured to calculate the "vector dot product" or inner product of two vectors. The following example illustrates the calculation of a vector dot product. Assuming vector **A** equals (x1, x2, x3), and vector **B** equals (y1, y2, y3), then the vector dot product A • B equals x1y1 + x2y2 + x3y3. As this example illustrates, calculation of the dot product entails performing a component-wise vector multiplication and then summing the vector component products.

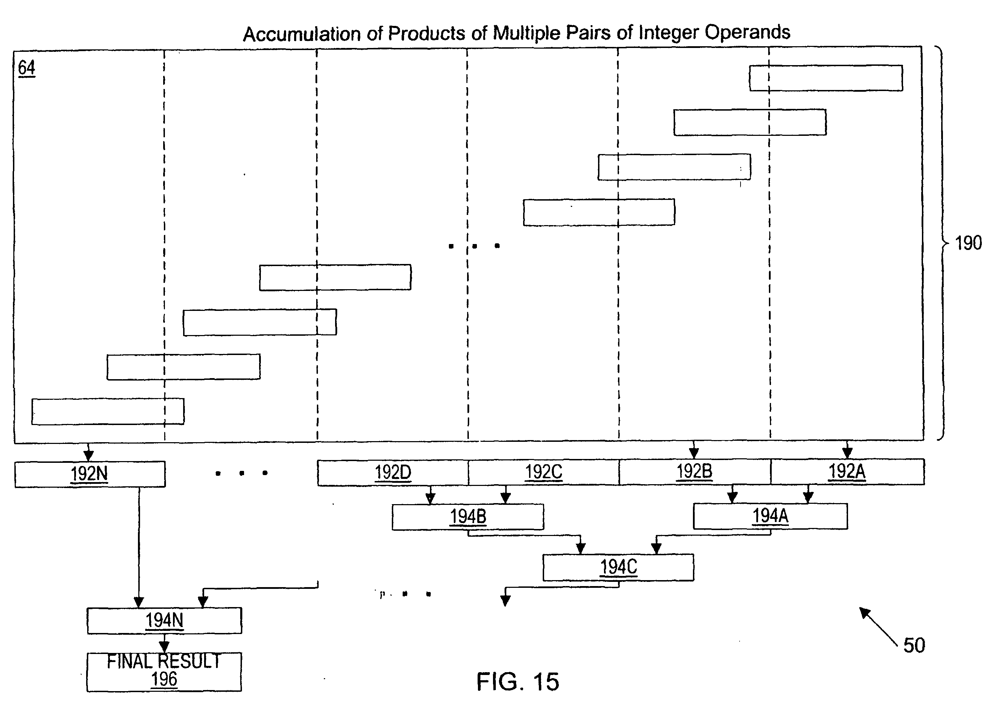

Turning now to Fig. 15, one embodiment of multiplier 50 configured to calculate the vector dot product is shown. As shown in the figure, partial products 190 are summed within adder 64 to form vector component products 192A-N, Each vector component product 192A-N corresponds to one vector pair within multiplicand operand 72 and multiplier operand 74 as previously disclosed. Vector component products 192A-N are then summed using a plurality of carry-propagate adders 194A-N to form final result 196, which may then be output for use by other parts of microprocessor 10.

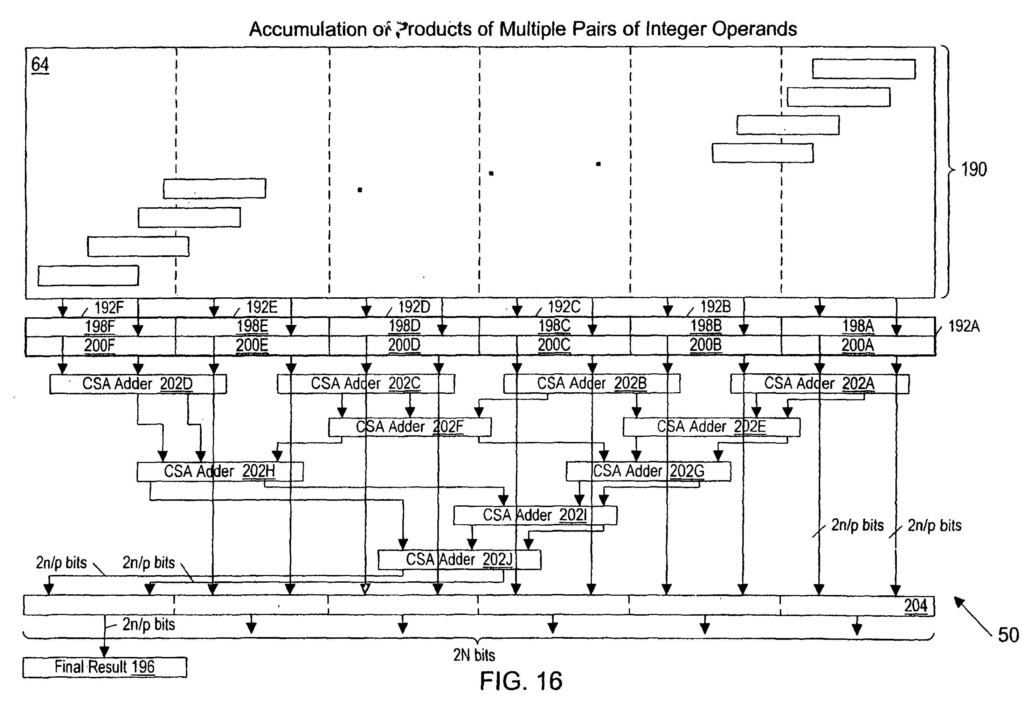

Turning now to Fig. 16, another embodiment of multiplier 50 configured to calculate the vector dot product is shown. In this embodiment, however, partial products 190 summed by adder 64 are kept in redundant form, i.e., each vector component product 192A-F is represented by more than one value. For example, each vector component product 192A-F may be represented by two values, a sum value 198A-F and a carry value 200A-F. A set of carry-save adders (not shown) may be used within adder 64 to sum partial products 192 in redundant form. Advantageously, carry-save adders may significantly reduce the amount of time and die space required to sum partial products 192. At the single-bit level, a carry-save adder will take three bits of the same significance and produce a sum value (having the same significance) and a carry value (having a significance one bit higher than the sum value). In contrast, the term "carry-propagate adder" denotes an adder that is not a carry-save adder. In one embodiment, a carry-save adder may be implemented as a number of independent full adders.

Once vector component products 192A-192F have been formed, they may be summed together using a second set of carry-save adders 202A-J. When the number of values remaining to be summed is reduced to two, a carry-propagate adder 204 may be used to perform the final summation. Note, however, that this configuration may require further modification if multiplier 50 is configured to propagate sign extension and carry bits as illustrated in Fig. 14. The embodiment of multiplier 50 illustrated in Fig. 14 relies upon carries from less significant products propagating into the more significant ones. In this case, summing partial products 190 and products 192A-F using carry-save adders may cause final result 196 to be less than the correct result by one unit-in-the-last-place (ULP) for each product below the most significant product. This is because carries from lower products are not incorporated into upper products during carry-save adds.

To ensure that final result 196 is correct when multiplier 50 is configured in a manner similar to the embodiment of Fig. 14, carry-propagate adder 204 may be configured to accept summands having a width equal to the cumulative width of all products 192A-F. Assuming the length of each operand (multiplier and multiplicand) is *n* bits wide and comprises *p* vector components, each product 192A-F will have a width of *2n*/*p.* Thus to accommodate all products 192A-192F, adder 204 may be 2*n* bits wide or wider. The redundant forms of each product 192-192F (e.g., sum values 198A-F and carry values 200A-F) are conveyed as inputs to adder 204 (excluding the most significant product 192F). In place of the most significant product 192F, the final two summands remaining from the carry-save summation of products 192A-192F are input to adder 204 as the most significant inputs. While adder 204 will output a 2*n*-bit wide result, only the most significant *2n*/*p* bits comprise the final result 196. This configuration advantageously allows adder 204 to propagate carry bits from lower order products to higher order products, thereby ensuring a proper result while still retaining the advantages associated with carry-save addition. Furthermore, the cost in die space of having a 2*n*-bit wide carry-propagate adder such as adder 204 may be reduced if other functions to performed by multiplier 50 also require a wide carry-propagate adder.

As with previous embodiments, this embodiment of multiplier 50 may be configured to accept operands having varying widths (*n*), and varying numbers of vector components (*p*). For example, multiplier 50 may be configured to calculate the dot product of two vector operands, each 64-bits wide and each having four vector components.

### Rounded Products

As previously noted, some embodiments of multiplier 50 may be configured to conserve hardware resources (e.g., signal lines and registers) by returning only a portion of the final product (or products, in the case of component-wise vector multiplication) per clock cycle. For example, the higher order bits of the final product may be returned first, and then the lower order bits may be returned in subsequent clock cycles. However, in some embodiments it may be advantageous to return the higher order bits rounded to the nearest unit in the last place ("ULP").

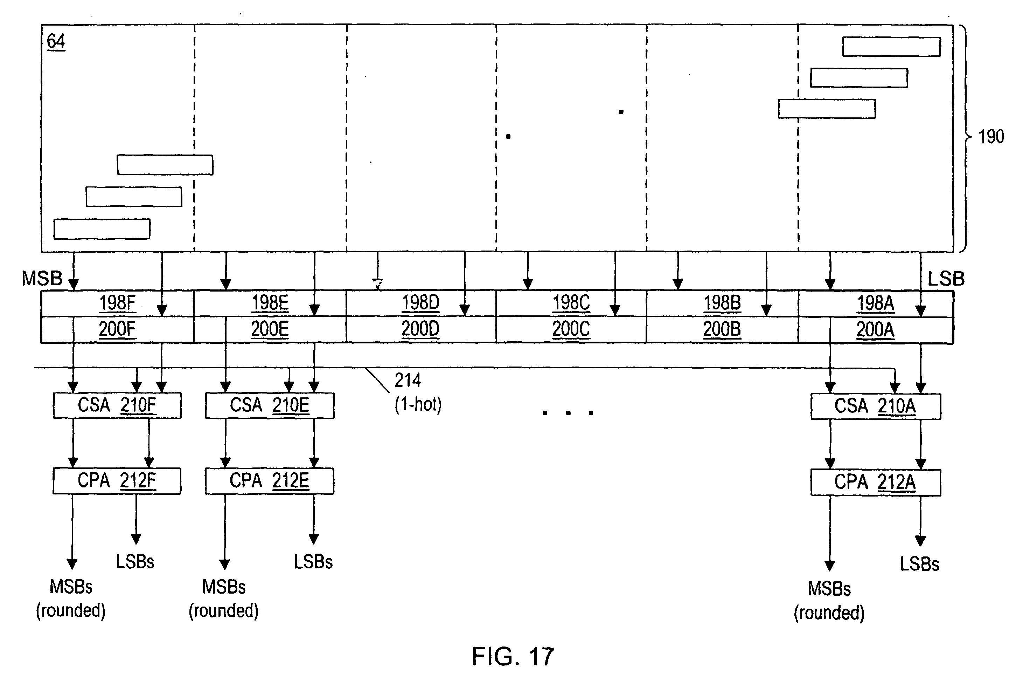

Turning now to Fig. 17, a diagram of another embodiment of multiplier 50 is shown. This embodiment is configured to round the higher order bits of each vector component product to the nearest ULP. As in the previous embodiment (illustrated in Fig. 16), partial products 190 are reduced in redundant form (e.g., a sum value and a carry value for each pairs of vector components) by adder 64. However, in this embodiment a plurality of adders 210A-210F are used to add a rounding constant 214 to each vector component product. Rounding constant 214 may comprise a single asserted bit (i.e., a "one-hot") added to the bit position below the least significant bit position in the portion of the vector component to be rounded. For example, assuming a vector component product has a width of 8 bits, and the four most significant bits (MSBs) are to be rounded, then a constant one would be added to the fourth bit (as illustrated in Table 2). By adding a constant one in the appropriate bit position, the upper portion of the vector component product may be rounded efficiently and without large amounts of additional logic.

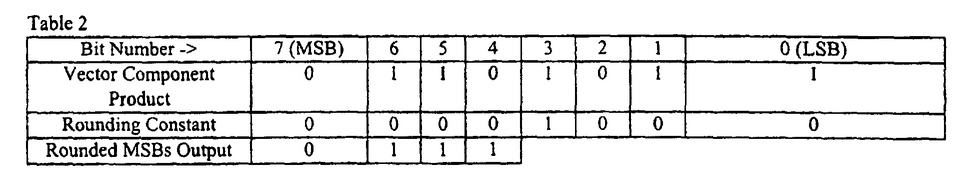

As shown in Fig. 17, each adder 210A-210F is configured to receive the redundant form of a single vector component product. For example, adder 210A is configured to receive sum value 198A and carry value 200A and combine them with rounding constant 214. Adder 210A combines these three values and generates a redundant form output comprising a new sum value and a new carry value. Advantageously, adders 210A-210F may be configured as independent carry-save adders, thereby preventing carry-bits caused by rounding constant 214 from propagating to more significant vector component products. The outputs of each adder 210A-210F are coupled to the inputs of one of a plurality of carry-propagate adders 212A-212F. Each carry-propagate adder 212A-212F is configured to sum the outputs of adders 210A-210F and thereby generate a non-redundant form of each vector component product. The rounded MSBs of each vector product may be output first, while the remaining least significant bits ("LSBs") may be output during a subsequent clock cycle. Adders 212A-212F may be configured independently to avoid the possibility of an unwanted carry-bit propagating across vector product boundaries.

In another embodiment, additional adders (not shown) may be configured to generate the LSBs (which are unrounded) separately from the MSBs. Advantageously, this may prevent the rounding process from altering the value of the LSBs. For example, adder 212A may be configured to generate the rounded MSBs by summing the sum and carry values generated by adder 210A, while an additional adder may be configured to sum the lower bits of sum value 198A and carry value 200A to generate the LSBs.

In the previously described embodiments, each adder 210A-210F and 212A-212F is configured to perform addition without propagating carry bits from one vector component product to another. While this may be desirable in many configurations, the non-propagation of carry bits may disrupt some configurations of adder 50. For example, the embodiment illustrated in Fig. 14 relies upon the propagation of sign extension bits across vector component product boundaries. If carry bits are not allowed to propagate during the final addition stages which convert the redundant-from vector component products to non-redundant-form, the higher order products may be incorrect.

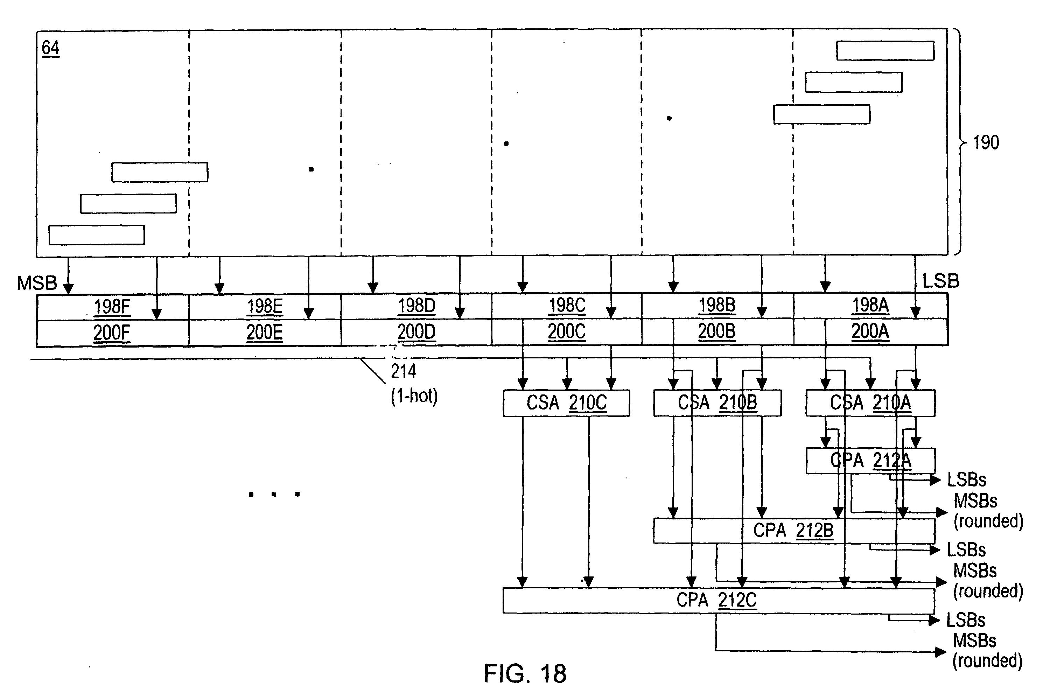

Turning now to Fig. 18, an embodiment of multiplier 50 which rounds the higher order bits of each vector component product, yet still allows carry bits to propagate across consecutive vector component product boundaries, is shown. In this embodiment, rounding constant 214 is once again added to the redundant form sum values 198A-198F and carry values 200A-200F of each vector component product by carry-save adders 210A-210F. In order to allow carries from partial products 190 to propagate without allowing carries from rounding constant 214 to propagate, separate carry-propagate adders 212A-212F are used for each vector component product. The length of each adder 212A-212F may equal the number of bits in the vector component product itself plus all of the bits corresponding to less significant vector component products. For example, assuming each vector component product is eight bits wide, adder 212B may be 16 bits wide and may add redundant vector component values 198A-198C and 200A-200C. Advantageously, undesired carry-out bits from each vector component product will not affect higher order vector component products in this configuration. Furthermore, the carry bits that may be required for correct operation of the embodiment of multiplier 50 illustrated in Fig. 14 still propagate to form the correct result despite possible sign-extensions.

Note that other configurations of multiplier 50 are possible. For example, rounding constant 214 may be incorporated within the logic of adder 64, thereby potentially eliminating the need for an extra level of adders. Furthermore, multiplier 50 may be configured to round and return the upper portions of scalar products and vector dot products in addition to vector component products. The types of adders used may also be changed according to the implementation, e.g., carry-propagate adders may be used through out in conjunction with multiplexers configured to prevent carry bits from propagating across vector component product boundaries. In addition, various control signals, e.g., a round_in signal, may be used to indicate whether rounding is to be performed.

## Claims

1. A multiplier (50) capable of vector multiplication and scalar multiplication comprising:
a multiplier input configured to receive a multiplier operand (74), wherein said multiplier operand comprises one of two forms, wherein said first form is a vector comprising a plurality of packed binary vector component values, wherein said second form is a scalar value;
a multiplicand input configured to receive a multiplicand operand (72), wherein said multiplicand operand comprises one of said first and second forms;
a partial product generator (60) coupled to said multiplicand input, wherein said partial product generator is configured to generate a plurality of partial products based upon said multiplicand operand; and
an adder (64) coupled to said partial product generator, wherein said adder is configured to sum the plurality of partial products generated by said partial product generator to form a final product, wherein said final product comprises one of said first and second forms;
**characterized in that** said adder is configured to sum a number of said partial products with a rounding constant (214) in order to form said final product, wherein said final product comprises a plurality of vector component products, wherein each of said vector component products is logically divided into portions, and wherein each of a selected vector component portion of said vector component product is rounded, said rounding being made in parallel.

2. The multiplier as recited in claim 1, further comprising a vector input (120) configured to receive a vector _ in signal indicative of whether said multiplier is to perform vector multiplication.

3. The multiplier as recited in claim 2, further comprising a first plurality of multiplexers (160A-E), coupled to said vector input and said partial product generator, wherein each multiplexer corresponds to a particular partial product and wherein each multiplexer is configured to conditionally zero-out a predetermined number of the least significant bits within the corresponding partial product upon receiving said vector_ in signal.

4. The multiplier as recited in claim 3, wherein said adder (64), is coupled to receive said vector_ in signal, wherein said adder is configured to sum said partial products without carrying bits from one of said plurality of packed binary values to another of said plurality of packed binary values upon receiving an asserted vector_in signal.

5. The multiplier as recited in claim 4, further comprising a second plurality of multiplexers, (162 A-E) coupled to said vector input and said partial product generator, wherein each of said second plurality of multiplexers corresponds to a particular partial product, and wherein each of said second plurality of multiplexers is configured to sign extend a portion of the corresponding partial product upon receiving an asserted vector_in signal.

6. The multiplier as recited in claim 5, wherein said partial product generator calculates said partial products by logically ANDing said multiplicand operand with each bit of said multiplier operand.

7. The multiplier as recited in claim 1, further comprising a multiplexer, coupled to said adder, wherein said multiplexer is configured to select and output said rounded portions during a first clock cycle, and wherein said multiplier is configured to output said non-rounded portions during subsequent clock cycles.

8. The multiplier as recited in claim 1, wherein said adder is configured to sum said partial products and said rounding constants in a carry-free fashion.

9. The multiplier as recited in claim 1, wherein said adder comprises:
a first plurality of adders 190, configured to reduce said partial products to a redundant form comprising a first sum value and first carry value;
a second plurality of adders (210A-F), coupled to said first plurality of adders, wherein said second plurality of adders are configured to combine said first sum values, said first carry values, and said rounding constants into a plurality of second sum values and a second carry values; and
a third plurality of adders (212A-F), coupled to said second plurality of adders, wherein said third plurality of adders are configured to combine said second sum values and said second carry values into a plurality of non-redundant final vector component products, wherein said non-redundant final vector component products comprise a number of logical portions, wherein a number of said logical portions are rounded.

10. The multiplier as recited in claim 9, wherein said third plurality of adders are configured to prevent carry-bits generated by said rounding constant from propagating to higher order vector component products.

11. The multiplier as recited in claim 9, wherein said first plurality of adders are carry-save adders configured to prevent carry-bits from propagating across vector component product boundaries (178).

12. The multiplier as recited in claim 9, wherein said first plurality of adders are carry-save adders configured to allow carry-bits generated by summation of said partial products to propagate across vector component product boundaries, wherein said carry-propagate adders are configured to prevent carries generated by said rounding constant from propagating across vector component boundaries (176).

13. the multiplier as recited in claim 1, wherein said adder comprises:
a first plurality of carry-propagate adders, (64) configured to sum said partial products to generate a plurality of vector component products, wherein said carry-propagate adders are configured to prevent carry-bits generated by the summation of said partial products from propagating across vector component product boundaries; and
a second plurality of carry-propagate adders, (212A-F) configured to sum said vector component products and said rounding constant to generate a plurality of rounded portions, wherein said carry-propagate adders are configured to prevent carry-bits caused by the summation of said vector component products and said rounding constant from propagating across vector component product boundaries.

14. The multiplier as recited in claim 10, further comprising an effective sign generator, (88A) configured to receive a sign-in bit and a most significant bit from a multiplicand operand as an inputs, wherein said effective sign generator is configured to output an effective sign bit, (90) corresponding to said multiplicand operand, wherein said partial product generator is coupled to receive said multiplicand operand and said effective sign bit, wherein said partial product generator is configured to generate said plurality of partial products using said multiplicand operand and said effective sign bit.

15. The multiplier as recited in claim 14, wherein said effective sign generator comprises a first AND gate (88A), coupled to receive said sign-in bit and said most significant bit from said multiplicand operand as inputs, wherein said first AND gate is configured to generate an effective sign, (90) for said multiplicand operand, wherein said effective sign for said multiplicand operand is used by said partial product generator to generate said partial products.

16. The multiplier as recited in claim 15, wherein said effective sign generator comprises a second AND gate, second AND gate is configured to generate an effective sign (92) for said multiplier operand, and wherein said effective sign for said multiplier operand is used by said selection logic unit together with said multiplier operand to select said number of partial products from said partial product generator.

## Patentansprüche

1. Multiplizierer (50) zur Vektormultiplikation und zur skalaren Multiplikation, mit:
- einem Multiplikatoreingang zum Empfangen eines Multiplikatoroperanden (74), wobei der Multiplikatoroperand eine von zwei Formen aufweist, wobei die erste Form ein Vektor mit mehreren gepackten binären Vektorkomponentenwerten ist, und wobei die zweite Form ein skalarer Wert ist;
- einem Multiplikandeneingang zum Empfangen eines Multiplikandenoperanden (72), wobei der Multiplikandenoperand entweder die erste oder die zweite Form aufweist;
- einem mit dem Multiplikandeneingang (60) verbundenen Teilproduktgenerator (60), wobei der Teilproduktgenerator zum Erzeugen mehrerer Teilprodukte basierend auf dem Multiplikandenoperanden ausgebildet ist; und
- einem mit dem Teilproduktgenerator verbundenen Addierer (64), wobei der Addierer zum Summieren der mehreren vom Teilproduktgenerator gebildeten Teilprodukte zur Bildung eines endgültigen Produkts ausgebildet ist, wobei das endgültige Produkt entweder die erste oder die zweite Form hat;
**dadurch gekennzeichnet, daß** der Addierer zum Summieren einerAnzahl von Teilprodukten mit einer Rundungskonstanten (214) ausgebildet ist, um das endgültige Produkt zu bilden, wobei das endgültige Produkt mehrere Vektorkomponentenprodukte aufweist, wobei jedes der Vektorkomponentenprodukte logisch in Bereiche geteilt ist, und wobei jeder ausgewählte Vektorkomponentenbereich des Vektorkomponentenprodukts gerundet ist, wobei das Runden parallel erfolgt.

2. Multiplizierer nach Anspruch 1, ferner mit einem Vektoreingang (120) zum Empfangen eines Vektor-Ein-Signals, das angibt, ob der Multiplizierer Vektormultiplikation durchführen soll.

3. Multiplizierer nach Anspruch 2, ferner mit einer ersten Vielzahl von Multiplexem (160A-E), die mit dem Vektoreingang und dem Teilproduktgenerator verbunden sind, wobei jeder Multiplexer einem bestimmten Teilprodukt entspricht und wobei jeder Multiplexer zum bedingten Nicht-Berücksichtigen einer vorbestimmten Anzahl der geringstwertigen Bits im entsprechenden Teilprodukt beim Empfangen des Vektor-Ein-Signals ausgebildet ist.

4. Multiplizierer nach Anspruch 3, bei dem derAddierer (64) zum Empfangen des Vektor-Ein-Signals vorgesehen ist, wobei derAddierer derart ausgebildet ist, daß er beim Empfangen eines angelegten Vektor-Ein-Signals die Teilprodukte ohne Übertrag von Bits von einer Vielzahl von gepackten binären Werten zu einer anderen Vielzahl von gepackten binären Werten summiert.

5. Multiplizierer nach Anspruch 4, ferner mit einer zweiten Vielzahl von Multiplexern (162 A-E) , die mit dem Vektoreingang und dem Teilproduktgenerator verbunden sind, wobei jeder der zweiten Vielzahl von Multiplexern einem bestimmten Teilprodukt entspricht und wobei jeder der zweiten Vielzahl von Multiplexern zur Vorzeichenerweiterung eines Teils des entsprechenden Teilprodukts beim Empfangen eines angelegten Vektor-Ein-Signals ausgebildet ist.

6. Multiplizierer nach Anspruch 5, bei dem der Teilproduktgenerator die Teilprodukte durch logisches UND-Verknüpfen des Multiplikandenoperanden mit jedem Bit des Multiplikatoroperanden berechnet.

7. Multiplizierer nach Anspruch 1, ferner mit einem mit dem Addierer verbundenen Multiplexer, wobei der Multiplexer zum Wählen und Ausgeben der gerundeten Teile während eines ersten Taktzyklus ausgebildet ist, und wobei der Multiplizierer zum Ausgeben der nicht gerundeten Teile in nachfolgenden Taktzyklen ausgebildet ist.

8. Multiplizierer nach Anspruch 1, bei dem derAddierer zum übertragslosen Summieren der Teilprodukte und der Rundungskonstanten ausgebildet ist.

9. Multiplizierer nach Anspruch 1, bei dem der Addierer aufweist:
- eine erste Vielzahl von Addierern (190), die zum Reduzieren der Teilprodukte auf eine redundante Form mit einem ersten Summenwert und einem ersten Übertragswert ausgebildet ist;
- eine zweite Vielzahl von Addierern (210A-F), die mit der ersten Vielzahl von Addierern verbunden ist, wobei die zweite Vielzahl von Addierern zum Kombinieren der ersten Summenwerte, der ersten Übertragswerte und der Rundungskonstanten zu einer Vielzahl von zweiten Summenwerten und zweiten Übertragswerten ausgebildet ist; und
- einer dritten Vielzahl von Addierern (212A-F), die mit der zweiten Vielzahl von Addierern verbunden ist, wobei die dritte Vielzahl von Addierern zum Kombinieren der zweiten Summenwerte und der zweiten Übertragswerte zu einer Vielzahl von nicht-redundanten endgültigen Vektorkomponentenprodukten ausgebildet ist, wobei die nicht-redundanten endgültigen Vektorkomponentenprodukte eine Anzahl logischer Bereiche aufweisen, von denen eine Anzahl gerundet ist.

10. Multiplizierer nach Anspruch 9, bei dem die dritte Vielzahl von Addierern zum Verhindern der Ausbreitung von durch die Rundungskonstante erzeugten Übertragsbits in Vektorkomponentenprodukte höherer Ordnung ausgebildet ist.

11. Multiplizierer nach Anspruch 9, bei dem die erste Vielzahl von Addierern Übertragsspeicheraddierer sind, die zum Verhindern der Ausbreitung von Übertragsbits über Vektorkomponentenproduktgrenzen (178) ausgebildet sind.

12. Multiplizierer nach Anspruch 9, bei dem die erste Vielzahl von Addierern Übertragsspeicheraddierer sind, die das Ausbreiten von durch Summieren derTeilprodukte entstandenen Übertragsbits über Vektorkomponentenproduktgrenzen ermöglichen, wobei die Übertragsausbreitungsaddierer zum Verhindern der Ausbreitung von durch die Rundungskonstante erzeugten Überträgen über Vektorkomponentengrenzen (176) ausgebildet sind.

13. Multiplizierer nach Anspruch 1, bei dem der Addierer aufweist:
- eine erste Vielzahl von Übertragsausbreitungsaddierern (64), die zum Summieren derTeilprodukte zur Erzeugung von Vektorkomponentenprodukten ausgebildet sind, wobei die Übertragsausbreitungsaddierer zum Verhindern des Ausbreitens von durch Summieren der Teilprodukte entstandenen Übertragsbits über Vektorkomponentenproduktgrenzen ausgebildet sind, und
- eine zweite Vielzahl von Übertragsausbreitungsaddierern (212A-F), die zum Summieren der Vektorkomponentenprodukte und der Rundungskonstante zur Erzeugung mehrerer gerundeterTeile ausgebildet sind, wobei die Übertragsausbreitungsaddierer zum Verhindern des Ausbreitens von durch Summieren der Vektorkomponentenprodukte und der Rundungskonstante entstandenen Übertragsbits über Vektorkomponentenproduktgrenzen ausgebildet sind.

14. Multiplizierer nach Anspruch 10, ferner mit einem Effektiv-Vorzeichen-Generator (88A), der zum Empfangen eines Vorzeichen-Ein-Bits und eines höchstwertigen Bits eines Multiplikandenoperanden als Eingang ausgebildet ist, wobei der Effektiv-Vorzeichen-Generator zum Ausgeben eines Effektiv-Vorzeichen-Bits (90) ausgebildet ist, das dem Multiplikandenoperanden entspricht, wobei der Teilproduktgenerator zum Empfangen des Multiplikandenoperanden und des Effektiv-Vorzeichen-Bits gekoppelt ist, wobei der Teilproduktgenerator zum Erzeugen der Vielzahl von Teilprodukten unter Verwendung des Multiplikandenoperanden und des Effektiv-Vorzeichen-Bits ausgebildet ist.

15. Multiptizierer nach Anspruch 14, bei dem der Effektiv-Vorzeichen-Generator ein erstes UND-Gatter (88A) aufweist, das zum Empfangen des Vorzeichen-Ein-Bits und des höchstwertigen Bits des Multiplikandenoperanden als Eingänge gekoppelt ist, wobei das erste UND-Gatterzum Erzeugen eines Effektiv-Vorzeichens (90) für den Multiplikandenoperanden ausgebildet ist, wobei das Effektiv-Vorzeichen für den Multiplikandenoperanden vom Teilproduktgenerator zum Erzeugen der Teilprodukte verwendet wird.

16. Multiplizierer nach Anspruch 15, bei dem der Effektiv-Vorzeichen-Generator ein zweites UND-Gatter aufweist, wobei das zweite UND-Gatter zum Erzeugen eines Effektiv-Vorzeichens (92) für den Multiplikatoroperanden ausgebildet ist, und wobei das Effektiv-Vorzeichen für den Multiplikatoroperanden von der Wähllogikeinheit zusammen mit dem Multiplikatoroperanden verwendet wird, um die Anzahl der Teilprodukte aus dem Teilproduktgenerator zu wählen.

## Revendications

1. Multiplicateur (50) capable d'effectuer une multiplication vectorielle et une multiplication scalaire comprenant :
une entrée de multiplicateur configurée pour recevoir un opérande de multiplicateur (74), dans lequel ledit opérande de multiplicateur comprend l'une de deux formes, dans lequel ladite première forme est un vecteur comprenant une pluralité de valeurs de composantes vectorielles binaires groupées, dans lequel ladite deuxième forme est une valeur scalaire ;
une entrée de multiplicande configurée pour recevoir un opérande de multiplicande (72), dans lequel ledit opérande de multiplicande comprend l'une desdites première et deuxième formes ;
un générateur de produits partiels (60) couplé à ladite entrée de multiplicande, dans lequel ledit générateur de produits partiels est configuré pour générer une pluralité de produits partiels sur la base dudit opérande de multiplicande ; et
un additionneur (64) couplé audit générateur de produits partiels, dans lequel ledit additionneur est configuré pour calculer la somme de la pluralité de produits partiels générés par ledit générateur de produits partiels afin de former un produit final, dans lequel ledit produit final comprend l'une desdites première et deuxième formes ;
**caractérisé en ce que** ledit additionneur est configuré pour calculer la somme d'un certain nombre desdits produits partiels et d'une constante d'arrondi (214) afin de former ledit produit final, dans lequel ledit produit final comprend une pluralité de produits de composantes vectorielles, dans lequel chacun desdits produits de composantes vectorielles est logiquement divisé en parties, et dans lequel chaque partie de composante vectorielle sélectionnée dudit produit de composantes vectorielles est arrondie, ledit arrondi étant effectué en parallèle.

2. Multiplicateur selon la revendication 1, comprenant en outre une entrée vectorielle (120) configurée pour recevoir un signal vector_in indicatif du fait que ledit multiplicateur doit effectuer une multiplication vectorielle.

3. Multiplicateur selon la revendication 2, comprenant en outre une première pluralité de multiplexeurs (160 A-E), couplés à ladite entrée vectorielle et audit générateur de produits partiels, dans lequel chaque multiplexeur correspond à un produit partiel particulier, et dans lequel chaque multiplexeur est configuré pour mettre à zéro conditionnellement un nombre prédéterminé des bits les moins significatifs dans le produit partiel correspondant lors de la réception dudit signal vector_in.

4. Multiplicateur selon la revendication 3, dans lequel ledit additionneur (64) est couplé pour recevoir ledit signal vector_in, dans lequel ledit additionneur est configuré pour calculer la somme desdits produits partiels sans reporter les bits de l'une de ladite pluralité de valeurs binaires groupées dans une autre de ladite pluralité de valeurs binaires groupées lors de la réception d'un signal vector_in actif.

5. Multiplicateur selon la revendication 4, comprenant en outre une deuxième pluralité de multiplexeurs (162 A-E) couplés à ladite entrée vectorielle et audit générateur de produits partiels, dans lequel chacun de ladite deuxième pluralité de multiplexeurs correspond à un produit partiel particulier, et dans lequel chacun de ladite deuxième pluralité de multiplexeurs est configuré pour effectuer une extension de signe sur une partie du produit partiel correspondant lors de la réception d'un signal vector_in actif.

6. Multiplicateur selon la revendication 5, dans lequel ledit générateur de produits partiels calcule lesdits produits partiels en effectuant une opération ET logique entre ledit opérande de multiplicande et chaque bit dudit opérande de multiplicateur.

7. Multiplicateur selon la revendication 1, comprenant en outre un multiplexeur couplé audit additionneur, dans lequel ledit multiplexeur est configuré pour sélectionner et sortir lesdites parties arrondies pendant un premier cycle d'horloge, et dans lequel ledit multiplicateur est configuré pour sortir lesdites parties non arrondies pendant les cycles d'horloge suivants.

8. Multiplicateur selon la revendication 1, dans lequel ledit additionneur est configuré pour calculer la somme desdits produits partiels et desdites constantes arrondies d'une manière sans retenue.

9. Multiplicateur selon la revendication 1, dans lequel ledit additionneur comprend :
une première pluralité d'additionneurs (190), configurés pour réduire lesdits produits partiels à une forme redondante comprenant une première valeur de somme et une première valeur de retenue ;
une deuxième pluralité d'additionneurs (210 A-F), couplés à ladite première pluralité d'additionneurs, dans lequel ladite deuxième pluralité d'additionneurs sont configurés pour combiner lesdites premières valeurs de somme, lesdites premières valeurs de retenue et lesdites constantes d'arrondi en une pluralité de deuxièmes valeurs de somme et de deuxièmes valeurs de retenue ; et
une troisième pluralité d'additionneurs (212 A-F), couplés à ladite deuxième pluralité d'additionneurs, dans lequel ladite troisième pluralité d'additionneurs sont configurés pour combiner lesdites deuxièmes valeurs de somme et lesdites deuxièmes valeurs de retenue en une pluralité de produits de composantes vectorielles finals non redondants, dans lequel lesdits produits de composantes vectorielles finals non redondants comprennent un certain nombre de parties logiques, dans lequel un certain nombre desdites parties logiques sont arrondies.

10. Multiplicateur selon la revendication 9, dans lequel ladite troisième pluralité d'additionneurs sont configurés pour empêcher que les bits de retenue générés par ladite constante arrondie ne se propagent vers les produits de composantes vectorielles d'ordre supérieur.

11. Multiplicateur selon la revendication 9, dans lequel ladite première pluralité d'additionneurs sont des additionneurs sans propagation de retenue configurés pour empêcher que les bits de retenue ne se propagent au-delà des limites de produits de composantes vectorielles (178).

12. Multiplicateur selon la revendication 9, dans lequel ladite première pluralité d'additionneurs sont des additionneurs sans propagation de retenue configurés pour permettre que les bits de retenue générés par le calcul de somme desdits produits partiels se propagent au-delà des limites de produits de composantes vectorielles, dans lequel lesdits additionneurs avec propagation de retenue sont configurés pour empêcher que les retenues générées par ladite constante d'arrondi ne se propagent au-delà des limites de produits de composantes vectorielles (176).

13. Multiplicateur selon la revendication 1, dans lequel ledit additionneur comprend :
une première pluralité d'additionneurs avec propagation de retenue (64) configurés pour calculer la somme desdits produits partiels afin de générer une pluralité de produits de composantes vectorielles, dans lequel lesdits additionneurs avec propagation de retenue sont configurés pour empêcher que les bits de retenue générés par le calcul de somme desdits produits partiels ne se propagent au-delà des limites de produits de composantes vectorielles ; et
une deuxième pluralité d'additionneurs avec propagation de retenue (212 A-F) configurés pour calculer la somme desdits produits de composantes vectorielles et de ladite constante d'arrondi afin de générer une pluralité de parties arrondies, dans lequel lesdits additionneurs avec propagation de retenue sont configurés pour empêcher que les bits de retenue générés par le calcul de somme desdits produits de composantes vectorielle et de ladite constante d'arrondi ne se propagent au-delà des limites de produits de composantes vectorielles.

14. Multiplicateur selon la revendication 10, comprenant en outre un générateur de signe réel (88A) configuré pour recevoir un bit sign_in et un bit le plus significatif d'un opérande de multiplicande en tant qu'entrées, dans lequel ledit générateur de signe réel est configuré pour sortir un bit de signe réel (90) correspondant audit opérande de multiplicande, dans lequel ledit générateur de produits partiels est couplé pour recevoir ledit opérande de multiplicande et ledit bit de signe réel, dans lequel ledit générateur de produits partiels est configuré pour générer ladite pluralité de produits partiels en utilisant ledit opérande de multiplicande et ledit bit de signe réel.

15. Multiplicateur selon la revendication 14, dans lequel ledit générateur de signe réel comprend une première porte ET (88A), couplée pour recevoir ledit bit sign_in et ledit bit le plus significatif dudit opérande de multiplicande en tant qu'entrées, dans lequel ladite première porte ET est configurée pour générer un signe réel (90) pour ledit opérande de multiplicande, dans lequel ledit signe réel pour ledit opérande de multiplicande est utilisé par ledit générateur de produits partiels pour générer lesdits produits partiels.

16. Multiplicateur selon la revendication 15, dans lequel ledit générateur de signe réel comprend une deuxième porte ET, dans lequel ladite deuxième porte ET est configurée pour générer un signe réel (92) pour ledit opérande de multiplicateur, et dans lequel ledit signe réel pour ledit opérande de multiplicateur est utilisé par ladite unité logique de sélection en même temps que ledit opérande de multiplicateur pour sélectionner ledit nombre de produits partiels provenant dudit générateur de produits partiels.
